# EUROPEAN PATENT APPLICATION

(11) **EP 2 492 956 A1**
(43) Date of publication of application: **29.08.2012**
(21) Application number: 10824628.1
(22) Date of filing: 13.10.2010
(51) Int. Cl.: H01L 21/60, H01L 21/02, H01L 25/065, H01L 25/07, H01L 25/18

(54) **PROCESS FOR PRODUCTION OF ELECTRONIC DEVICE, ELECTRONIC DEVICE, AND DEVICE FOR PRODUCTION OF ELECTRONIC DEVICE**

(30) Priority: 19.10.2009 JP 2009240409; 12.03.2010 JP 2010055329; 31.03.2010 JP 2010080453
(71) Applicant: Sumitomo Bakelite Co., Ltd., Shinagawa-ku Tokyo 140-0002 (JP)
(72) Inventor: MEURA, Toru, Tokyo 140-0002 (JP); NIKAIDO, Hiroki, Tokyo 140-0002 (JP); MAEJIMA, Kenzou, Tokyo 140-0002 (JP); ISHIMURA, Yoji, Tokyo 140-0002 (JP); YOSHIDA, Kenji, Tokyo 140-0002 (JP)
(74) Representative: Vossius, Corinna
(86) International application number: PCT/JP2010/006071
(87) International publication number: WO 2011/048774

(57) **Abstract**

Disclosed is a method of manufacturing an electronic device, the method includes obtaining a stack (4) of the first electronic component (1) and the second electronic component (2), while placing a resin layer (3) which contains a flux-active compound and a thermosetting resin, between the first terminals (11) and the second terminals (21); bonding the first terminals (11) and the second terminals (21) with solder, by heating the stack (4) at a temperature not lower than the melting point of solder layers (112) on the first terminals (11), while pressurizing the stack (4) using a fluid; and curing the resin layer (3), wherein in the process of bonding the first terminals (11) and the second terminals (21) with solder, the duration from the point of time immediately after the start of heating of the stack (4), up to the point of time when the temperature of the stack (4) reaches the melting point of the solder layers (112), is set to 5 seconds or longer, and 15 minutes or shorter.

## Description

### TECHNICAL FIELD

The present invention relates to a method of manufacturing an electronic device, an electronic device, and an apparatus for manufacturing an electronic device.

### BACKGROUND ART

Electronic devices are manufactured typically by bonding terminals of a semiconductor element to terminals of another semiconductor element, terminals of a semiconductor element to terminals of a substrate, or terminals of a substrate to terminals of another substrate with solder.

Since a gap is formed between the semiconductor elements, between the semiconductor element and the substrate, or between the substrates bonded with solder (referred to as "between the semiconductor elements or the like", hereinafter), the gap is necessarily be filled with a cured product of resin. Conventionally, the gap formed between the semiconductor elements or the like has been filled, after bonding with solder, by injecting a fluidic thermosetting resin between the semiconductor elements or the like, and then by curing the resin.

In contrast, a recent growing trend is such as placing, before the bonding with solder, a flux-containing resin layer between the semiconductor elements or the like, heating the article at a temperature not lower than the melting point of a solder to effect solder bonding, and then curing the resin layer.

For example, Japanese Laid-Open Patent Publication No. H03-184695 (Patent Document 1) discloses a solder paste which contains an epoxy resin as a major constituent, an organic acid or an organic acid salt, and a solder particle. Japanese Laid-Open Patent Publication No. 2001-311005 (Patent Document 2) discloses a thermosetting resin sheet formed by using a composition which contains at least one thermosetting resin selected from epoxy-based resin, phenolic resin, diallyl phthalate-based resin, and benzocyclobutene-based resin, and a flux component.

It is, however, still difficult for the above-described methods to thoroughly fill the fluidic thermosetting resin between the semiconductor elements or the like without causing voids. A method described below has been proposed by Patent Document 3.
Patent Document 3 discloses a method and an apparatus, by which a filmy underfill resin is placed over the surface of a substrate, and then a semiconductor element is mounted on the underfill resin. According to Patent Document 3, the semiconductor element is mounted on the underfill resin preliminarily placed over the substrate, the semiconductor element is pressed against the substrate, the semiconductor element and the substrate are bonded by fusing solder bumps, and the underfill resin is then cured in a high-pressure atmosphere.

### RELATED DOCUMENT

### [Patent Document]

[Patent Document 1] Japanese Laid-Open Patent Publication No. H03-184695 (Claims)
[Patent Document 2] Japanese Laid-Open Patent Publication No. 2001-311005 (Claims)
[Patent Document 3] Japanese Laid-Open Patent Publication No. 2004-311709

### DISCLOSURE OF THE INVENTION

### [Problems to be Solved by the Invention]

However, even with the techniques disclosed in Patent Documents 1 and 2, bonding failure would sometimes occur in the process of bonding of the terminals.

In addition, the manufacturing apparatus disclosed in Patent Document 3 is not suitable for mass production, since a stack should have been formed by bonding the semiconductor elements one-by-one to the substrate, and then by fusing the solder bumps to thereby bond the semiconductor elements and the substrate.
The present inventors then examined a method of conducting a reflow process, while applying load onto a plurality of stacks.
The method, however, revealed a problem below. If the load is applied in the reflow process onto the plurality of stacks by placing a weight, the resin placed between the semiconductor element and the substrate would sometimes run out of the gap between the semiconductor elements and the substrate. If the amount of run-out of the resin is large, the resin is anticipated to fill a space surrounded by the adjacent stacks and the weight.
In this case, if a gas should generate from the resin, the gas has no path to leak therethrough, and thereby forms voids in the resin. The voids could be causative of bonding failure between the semiconductor elements and the substrate.

A method capable of manufacturing electronic devices of higher reliability has therefore been desired.

### [Means for Solving the Problems]

According to a first aspect of the present invention, there is provided a method of manufacturing an electronic device which has a first electronic component and a second electronic component, the first electronic component having a first terminal having formed on the surface thereof a solder layer, and the second electronic component having a second terminal to be bonded to the first terminal of the first electronic component. The method includes:
obtaining a stack of the first electronic component and the second electronic component, while placing between the first terminal and the second terminal a resin layer which contains a flux-active compound and a thermosetting resin;
bonding the first terminal and the second terminal with solder, by heating the stack at a temperature not lower than the melting point of the solder layer on the first terminal, while pressurizing the stack using a fluid; and
curing the resin layer.
In the process of bonding the first terminal and the second terminal with solder,
the duration from the point of time immediately after the start of heating of the stack, up to the point of time when the temperature of the stack reaches the melting point of the solder layer, is set to 5 seconds or longer, and 15 minutes or shorter.

In the process of bonding the first terminal and the second terminal with solder, the duration from the point of time immediately after the start of heating of the stack, up to the point of time when the temperature of the stack reaches the melting point of the solder, is set to 5 seconds or longer, and 15 minutes or shorter.
By rapidly heating the stack in this way, the first terminal and the second terminal may tightly be bonded.
As a consequence, an electronic device of higher reliability may be manufactured by the first aspect of the invention.
The process of curing the resin layer may be proceeded concomitantly with the process of conducting solder bonding, or may succeed the solder bonding.

The first aspect of the invention may also provide an electronic device manufactured by the method described in the above.

According to the second aspect of the present invention, there is provided a method of manufacturing an electronic device which has a first electronic component and a second electronic component, the first electronic component having a first terminal having formed on the surface thereof a solder layer, and the second electronic component having a second terminal to be bonded to the first terminal of the first electronic component. The method includes:
obtaining a stack of the first electronic component and the second electronic component, while placing between the first terminal and the second terminal a resin layer which contains a flux-active compound and a thermosetting resin;
bonding the first terminal and the second terminal with solder, by heating the stack at a temperature not lower than the melting point of the solder layer on the first terminal; and
curing the resin layer while pressurizing the stack using a fluid.
The process of bonding the first terminal and the second terminal with solder further includes:
preparing a plurality of the stacks and a member having trenches formed thereon;
bringing the individual areas of the member, partitioned by the trenches, into contact with the first electronic components or the second electronic components of the individual stacks;
concomitantly opposing the trenches of the member, to gaps formed between the adjacent stacks and formed between the adjacent components brought into contact with the individual areas partitioned by the trenches; and
bonding the first terminals and the second terminals with solder, by heating the individual stacks at a temperature not lower than the melting point of the solder layers on the first terminals, while pressurizing the individual stacks in the direction of stacking thereof.

According to the second aspect of the invention, the individual stacks are applied with load, while being brought into contact with the member having the trenches formed thereon. Accordingly, even if the resin should run out from the individual stacks, and a gas should generate from the resin, the gas may be leaked into the trenches, and thereby the voids may be prevented from generating in the resin layer.
Accordingly, a highly reliable electronic device may be provided also by the second aspect of the invention.

The present invention may also provide a manufacturing apparatus used for the above-described method of manufacturing.
According to the present invention, there is provided an apparatus for manufacturing an electronic device which has a first electronic component and a second electronic component, the first electronic component having a first terminal having formed on the surface thereof a solder layer, and the second electronic component having a second terminal to be bonded to the first terminal of the first electronic component. The apparatus includes:
a container in which a plurality of stacks, each obtained by stacking the first electronic component and the second electronic component, while placing between the first terminal and the second terminal a resin layer which contains a flux-active compound and a thermosetting resin, are arranged;
a heating unit heating the stacks in the container up to a temperature not lower than the melting point of the solder layers on the first terminals;
a pressurized fluid introducing unit introducing a pressurized fluid into the container; and
a clamping unit clamping the plurality of stacks in the container in the direction of stacking of the stacks, and applying load onto the individual stacks in the direction of stacking of the individual stacks.
The clamping unit is configured:
to have a member having trenches formed thereon; and so that,
when the individual stacks are clamped by the clamping unit, the first electronic components or the second electronic components of the individual stacks are brought into contact with the individual areas of the member partitioned by the trenches; and
the trenches of the member are opposed to gaps formed between the adjacent stacks and formed between the adjacent components brought into contact with the individual areas partitioned by the trenches.

### [Effects of the Invention]

According to the present invention, a method of manufacturing an electronic device capable of manufacturing a highly-reliable electronic device, an electronic device manufactured by the method, and an apparatus for manufacturing an electronic device may be provided.

### BRIEF DESCRIPTION OF THE DRAWINGS

FIG. 1 is a drawing illustrating a process of manufacturing of an electronic device according to a first embodiment;
FIG. 2 is a drawing illustrating a process of manufacturing of the electronic device illustrated in FIG. 1;
FIG. 3 is a drawing illustrating a process of manufacturing of the electronic device illustrated in FIG. 1;
FIG. 4 is a drawing illustrating an apparatus used for manufacturing the electronic device illustrated in FIG. 1;
FIG. 5 is a drawing illustrating an electronic device manufactured by the process of manufacturing of an electronic device illustrated in FIG. 1;
FIG. 6 is a drawing illustrating an apparatus for manufacturing an electronic device according to a second embodiment;
FIG. 7 is a drawing illustrating a process of manufacturing of an electronic device according to a third embodiment;
FIG. 8 is a drawing illustrating a process of manufacturing of the electronic device illustrated in FIG. 7;
FIG. 9 is a drawing illustrating a process of manufacturing of the electronic device illustrated in FIG. 7;
FIG. 10 is a drawing illustrating an apparatus used for manufacturing the electronic device illustrated in FIG. 7;
FIG. 11 is a drawing illustrating a member of the manufacturing apparatus illustrated in FIG. 10;
FIG. 12 is a drawing illustrating a process of manufacturing of the electronic device illustrated in FIG. 7;
FIG. 13 is a drawing illustrating an electronic device manufactured by the process of manufacturing of an electronic device illustrated in FIG. 7; and
FIG. 14 is a drawing illustrating an apparatus for manufacturing an electronic device according to a fourth embodiment.

### DESCRIPTION OF THE EMBODIMENTS

Embodiments of the present invention will be explained below, referring to the attached drawings.

### (First Embodiment)

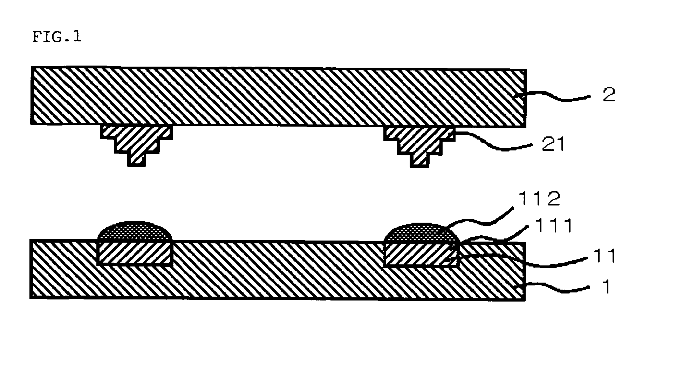

A method of manufacturing an electronic device according to a first embodiment will be outlined, referring to FIGs. 1 to 5. The first embodiment relates to an embodiment according to the first aspect of the invention.
The method of manufacturing an electronic device of this embodiment is aimed at manufacturing an electronic device which has a first electronic component 1 having first terminals 11 having formed on the surface thereof solder layers 112, and a second electronic component 2 having second terminals 21 to be bonded to the first terminals 11 of the first electronic component 1. The method includes:
obtaining a stack 4 of the first electronic component 1 and the second electronic component 2, while placing a resin layer 3 which contains a flux-active compound (a compound having a flux activity) and a thermosetting resin, between the first terminals 11 and the second terminals 21;
bonding the first terminals 11 and the second terminals 21 with solder, by heating the stack 4 at a temperature not lower than the melting point of the solder layers 112 on the first terminals 11, while pressurizing the stack 4 using a fluid; and
curing the resin layer 3.
In the process of bonding the first terminals 11 and the second terminals 21 with solder,
the duration from the point of time immediately after the start of heating of the stack 4, up to the point of time when the temperature of the stack 4 reaches the melting point of the solder layers 112, is set to 5 seconds or longer, and 15 minutes or shorter.

Next, the method of manufacturing an electronic device of this embodiment will be detailed.
First, as illustrated in FIG. 1, the first electronic component 1 is prepared.
The first electronic component 1 is typically a substrate (flexible substrate, rigid substrate, ceramic substrate, etc.), a semiconductor chip, a substrate having semiconductor element(s) mounted thereon, or the like.
The first electronic component 1 has the first terminals 11, wherein each first terminal 11 has a first terminal body 111, and the solder layer 112 provided on the surface of the first terminal body 111.
Examples of geometry of the first terminal body 111 include convex and concave, without special limitation. Examples of material composing the first terminal body 111 include gold, copper, nickel, palladium and aluminum, without special limitation.
Materials for composing the solder layer 112 are not specifically limited, and examples of which include alloys containing at least two species selected from the group consisting of tin, silver, lead, zinc, bismuth, indium and copper. Among them, alloys containing at least two species selected from the group consisting of tin, silver, lead, zinc and copper are preferable. Melting point of the solder layer 112 is 110 to 250°C, preferably 170 to 230°C.
The solder layer 112 may be configured by a plated layer of solder formed on the first terminal body 111, or by a solder bump formed by placing a solder ball or solder paste on the first terminal body 111.

Next, the second electronic component 2 is prepared (see FIG. 1).
The second electronic component 2 is typically a semiconductor chip, or a substrate having an semiconductor element mounted thereon.
The second electronic component 2 has the second terminals 21. Examples of geometry of the second terminals 21 are not specifically limited so long as they may be bonded to the first terminals 11 using solder, and include convex and concave. Examples of material composing the second terminals 21 include gold, copper, nickel, palladium and aluminum, without special limitation.

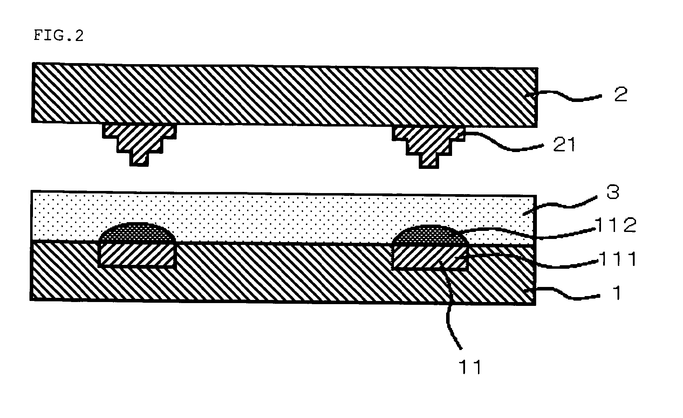

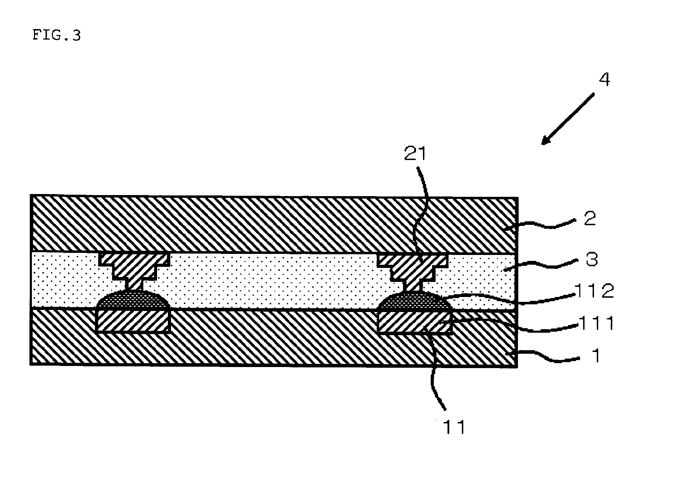

Next, as illustrated in FIG. 2, the resin layer 3 which contains a flux-active compound and a thermosetting resin is placed between the first terminals 11 of the first electronic component 1 and the second terminals 21 of the second electronic component 2, and the first terminals 11 and the second terminals 21 are positionally aligned. In this process, the second terminals 21 are intruded into the resin layer 3 so as to bring themselves into contact with the first terminals 11, to thereby obtain the stack 4 (see FIG. 3).
In order to bring the first terminals 11 into contact with the second terminals 21, the stacking of the first electronic component 1 and the second electronic component 2, while placing the resin layer 3 in between, may be followed by heating. Note that, in the alignment process in this case, the first terminals 11 and the second terminals 21 will not be bonded with solder, with the aid of the solder layers 112 on the first terminals 11.
The resin layer 3 is configured using a thermosetting resin capable of filling up the gap between the first electronic component 1 and the second electronic component 2, without special limitation.
Examples of the thermosetting resin contained in the resin layer 3 include epoxy resin, oxetane resin, phenolic resin, (meth) acrylate resin, unsaturated polyester resin, diallyl phthalate resin, and maleimide resin. They may be used alone, or in combination of two or more species.
Among others, epoxy resin is preferably used by virtue of its excellence in curability, storability, heat resistance of the cured product, moisture resistance, and chemical resistance.

The minimum melt viscosity of the resin layer 3 at 100 to 200°C is preferably 1 to 1000 Pa·s, and particularly preferably 1 to 500 Pa·s. By adjusting the minimum melt viscosity of the resin layer 3 at 100 to 200°C to the above-described ranges, the cured product is less likely to have voids generated therein. The melt viscosity may be measured typically using a rheometer, a sort of viscoelasticity analyzer, by applying shear to a filmy sample at a frequency of 1 Hz, while heating the sample at a rate of elevation of temperature of 10°C/min.

The resin layer 3 acts, in the process of solder bonding, to remove an oxide film naturally formed on the surface of the solder layer 112. By the contribution of the flux activity owned by the resin layer 3, the oxide film which covers the surface of the solder layer 112 is removed, and the solder bonding may proceed. For ensuring the flux activity of the resin layer 3, the resin layer 3 necessarily contains a flux activation compound. The flux-active compound contained in the resin layer 3 preferably has either carboxyl group or phenolic hydroxy group, or has both of carboxyl group and phenolic hydroxy group, without special limitation so long as it is adoptable to solder bonding.

Amount of addition of the flux-active compound in the resin layer 3 is preferably 1 to 30% by weight, and particularly preferably 3 to 20% by weight. By adjusting the amount of addition of the flux-active compound in the resin layer 3 within the above-described ranges, the resin layer may be improved in the flux activity, and may prevent the flux-active compound from remaining, in the resin layer, unreacted with the thermosetting resin. Residue of the unreacted flux-active compound may induce migration.

Some of the compounds capable of acting as a hardener of the thermosetting resin are also capable of expressing the flux activity (this sort of compounds will also be referred to as "flux-active hardener", hereinafter). For example, phenolic novolac resin, cresol novolac resin, aliphatic dicarboxlic acid, and aromatic dicarboxylic acid, which act as hardeners of epoxy resin, also have the flux activity. The resin layer 3 containing, as the hardener of thermosetting resin, this sort of flux-active hardener capable of acting the flux-active compound and also as the hardener of thermosetting resin, may be given as a resin layer having flux activity.

Note that the flux-active compound having carboxyl group means compounds having one or more carboxyl groups in the molecule thereof, and may be liquid or solid. The flux-active compound having phenollic hydroxy group means compounds having one or more phenolic hydroxyl groups, and may be liquid or solid. The flux-active compound having both of carboxyl group and phenolic hydroxy group means compounds having one or more carboxyl groups and one or more phenolic hydroxy groups, and may be liquid or solid.

Among them, examples of the flux-active compound having carboxyl group include aliphatic acid anhydride, alicyclic acid anhydride, aromatic acid anhydride, aliphatic carboxylic acid, and aromatic carboxylic acid.

Examples of the aliphatic acid anhydride, representing the flux-active compound having carboxyl group, include succinic anhydride, poly(adipic anhydride), poly(azelaic anhydride), and poly(sebacic anhydride).

Examples of the alicyclic acid anhydride, representing the flux-active compound having carboxyl group, include methyl tetrahydrophthalic anhydride, methyl hexahydrophthalic anhydride, methyl himic anhydride, hexahydrophthalic anhydride, tetrahydrophthalic anhydride, trialkyl tetrahydrophthalic anhydride, and methylcyclohexene dicarboxylic anhydride.

Examples of the aromatic acid anhydride, representing the flux-active compound having carboxyl group, include phthalic anhydride, trimellitic anhydride, pyromellitic anhydride, benzophenonetetracarboxylic anhydride, ethylene glycol bistrimellitate, and glycerol tristrimellitate.

Examples of the aliphatic carboxylic acid, representing the flux-active compound having carboxyl group, include compounds represented by the formula (1) below, formic acid, acetic acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, and succinic acid:

HOOC-(CH₂)ₙ-COOH (1)

(in the formula (1), n represents an integer of 0 or larger and 20 or smaller).

Examples of the aromatic carboxylic acid, representing the flux-active compound having carboxyl group, include benzoic acid, phthalic acid, isophthalic acid, terephthalic acid, hemimellitic acid, trimellitic acid, trimesic acid, mellophanic acid, prehnitic acid, pyromellitic acid, mellitic acid, toluic acid, xylylic acid, hemellitic acid, mesitylenic acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid), naphthoeic acid derivatives such as 1,4-dihydroxy-2-naphthoeic acid and 3,5-dihydroxy-2-naphthoeic acid, phenolphthalein, and diphenolic acid.

Among these flux-active compound having carboxyl group, the compounds represented by the formula (1) are preferable, in view of a good balance among activity of the flux-active compound, amount of generation of outgas in the process of curing of the resin layer, elastic modulus of the resin layer after being cured, glass transition temperature and so forth. Further among the compounds represented by the formula (1), the compounds having a value of "n" in the formula (1) of 3 to 10 are particularly preferable, in view of suppressing the elastic modulus of the resin layer after being cured from increasing, and of improving the adhesiveness between the first electronic component 1 and the second electronic component 2.

Examples of the compounds having a value of "n" of 3 to 10, among the compounds represented by the formula (1), include glutaric acid (HOOC-(CH₂)₃-COOH) with n=3, adipic acid (HOOC-(CH₂)₄-COOH) with n=4, pimeric acid (HOOC-(CH₂)₅-COOH) with n=5, sebacic acid (HOOC-(CH₂)₈-COOH) with n=8, and HOOC-(CH₂)₁₀-COOH with n=10.

Examples of the flux-active compound having phenolic hydroxy group include phenols, which are specifically monomers having phenolic hydroxy group(s) such as phenol, o-cresol, 2,6-xylenol, p-cresol, m-cresol, o-ethylphenol, 2,4-xylenol, 2,5-xylenol, *m*-ethylphenol, 2,3-xylenol, meditol, 3,5-xylenol, p-tertiary butyl phenol, catechol, p-tertiary amyl phenol, resorcinol, p-octyl phenol, p-phenylphenol, bisphenol A, bisphenol F, bisphenol AF, biphenol, diallyl bisphenol F, diallyl bisphenol A, tris-phenol, and tetrakis-phenol; phenolic novolac resin, o-cresol novolac resin, bisphenol F novolac resin, and bisphenol A novolac resin.

The above-described compounds having either carboxyl group or phenolic hydroxy group, or both of carboxyl group and phenolic hydroxy group are incorporated in a three-dimensional manner, after reacting with a thermosetting resin such as epoxy resin.

Accordingly, from the viewpoint of enhacing formation of a three-dimensional network of the epoxy resin after being cured, the flux-active compound is preferably a flux-active hardener which has a flux activity and acts as a hardener of epoxy resin. Examples of the flux-active hardener include compounds having, in a single molecule thereof, two or more phenolic hydroxy groups capable of adding to epoxy resin, and one or more carboxyl group directly bound to an aromatic group which exhibits the flux activity (reductivity) . Examples of this sort of flux-active hardener include benzoic acid derivatives such as 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid, and gallic acid (3,4,5-trihydroxybenzoic acid); and naphthoeic acid derivatives such as 1,4-dihydroxy-2-naphthoeic acid, 3,5-dihydroxy-2-naphthoeic acid, and 3,7-dihydroxy-2-naphthoeic acid; phenolphthalein; and diphenolic acid. They may be used alone, or in combination of two or more species.
Among them, phenolphthalein is particularly preferably used, in view of ensuring a good bonding between the first terminals 11 and the second terminals 21. By using phenolphthalein, it is supposed that the epoxy resin may be cured after an oxide on the surface of the solder layer 112 is removed, so that the epoxy resin is prevented from curing while leaving the oxide on the surface of the solder layer 112 unremoved, and thereby solder bonding of the first terminal 11 and the second terminal 21 may be improved.

Amount of addition of of the flux-active hardener in the resin layer 3 is preferably 1 to 30% by weight, and particularly preferably 3 to 20% by weight. By adjusting the amount of addition of the flux-active hardener in the resin layer 3 within the above-described ranges, the flux activity of the resin layer may be improved, and the flux-active hardener may be prevented from remaining, in the resin layer, unreacted with the thermosetting resin. Residue of the unreacted flux-active hardener may induce migration.
The resin layer 3 may also include an inorganic filler.
By containing the inorganic filler in the resin layer 3, minimum melt viscosity of the resin layer 3 may be increased, and thereby a gap is prevented from generating between the first terminals 11 and the second terminals 21. If the minimum melt viscosity of the resin layer 3 is very small, the resin layer 3 will be highly fluidic, and may intrude between the first terminals 11 and the second terminals 21, to thereby separate the first terminals 11 and the second terminals 21.
Examples of the inorganic filler include silica and alumina.

The resin layer 3 may still also contain a curing catalyst.
The curing catalyst may appropriately be selected depending on species of the thermosetting resin in the resin layer 3, wherein imidazole compound may be used from the viewpoint of improving the film formability. Examples of the imidazole compound include 2-phenyl hydroxyimidazole, and 2-phenyl-4-methyl hydroxyimidazole.

Ratio of mixing of the curing catalyst is typically adjusted to 0.01% by weight or more and 5% by weight or less, assuming the total of the constituents of the resin layer 3 as 100. By adjusting the ratio of mixing of the curing catalyst to 0.01% by weight or more, the function of the curing catalyst may more effectively be expressed, to thereby improve the curability of the resin layer 3. On the other hand, by adjusting the ratio of mixing of the curing catalyst to 5% by weight or less, the storability of the resin layer 3 may further be improved.

Methods of placing the resin layer 3 between the first electronic component 1 and the second electronic component 2 include:
(1) preparing a resin film made of a resin composition containing a flux-active compound, and laminating the resin film onto the first electronic component 1 or the second electronic component 2;
(2) preparing a liquid or pasty resin composition containing a flux-active compound, and coating the liquid or pasty resin composition on the surface of the first electronic component 1 or the second electronic component 2; and
(3) preparing a resin varnish obtained by dissolving or dispersing a resin composition, which contains a flux-active compound, into a solvent, coating the resin varnish on the surface of the first electronic component 1 or the second electronic component 2, and then vaporizing off the solvent in the resin varnish.
Note that the liquid resin composition used in (2) does not contain a solvent.

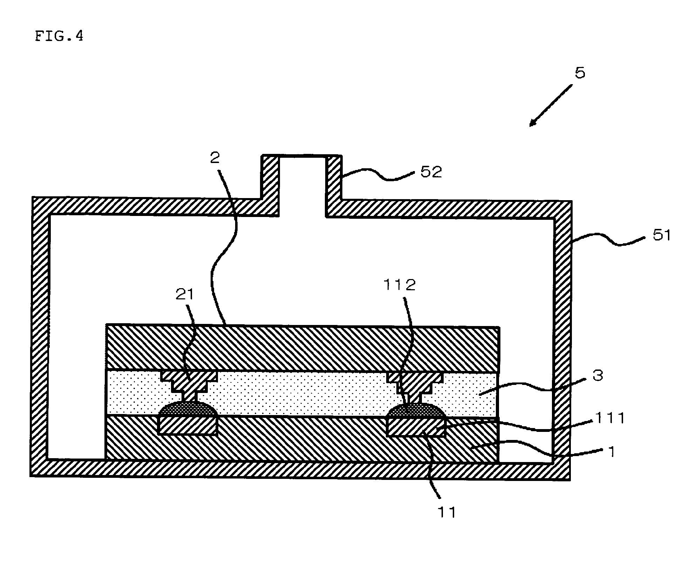

Thereafter, using an apparatus 5 illustrated in FIG. 4, the stack 4 is heated to a temperature not lower than the melting point of the solder layers 112 on the first terminals 11, under pressure applied through a fluid, to thereby bond the first terminals 11 and the second terminals 21 with solder.
The apparatus 5 is designed to heat the stack 4 in a pressurized atmosphere, and is typically configured to have a container 51 capable of housing therein the stack 4, and a pipe 52 through which the fluid is introduced into the container 51.

The container 51 is characteristically a pressure container, and is designed to pressurize the stack 4 under heating, by placing the stack 4 in the container 51 and then introducing a heated fluid through the pipe 52 into the container 51.
Another possible method is to allow the fluid to flow through the pipe 52 into the container 51 so as to prepare a pressurized atmosphere, and then to heat the stack 4 by heating the container 51.
The container 51 may be made of metal, such as stainless steel, titanium or copper.
In order to accelerate the rate of elevation of temperature of the stack 4, it is effective to preliminarily heat the container 51 at a predetermined temperature.
For the case where the stack 4 is heated by introducing a heated fluid into the container 51, it is effective to wrap the container with a heat insulating material so as to suppress radiation of heat therefrom, or to float the stack 4 in the container 51 using pins, so as to reduce the area of contact between the stack 4 and the container 51.
On the other hand, for the case where the stack 4 is heated by heating the container 51 *per* se, it is effective to place the stack 4 in a close proximity with the container. Alternatively, the stack 4 may rapidly be heated by heating the container 51 using a heater having a large heating capacity.
For the rapid heating of the stack 4, the container 51 preferably has a small volumetric capacity. The container illustrated in FIG. 4 typically has a width of approximately 200 mm, a height of approximately 10 mm, and a depth of approximately 100 mm.

Pressure for pressurizing the stack 4 through the fluid is 0.1 MPa or above and 10 MPa or below, and preferably 0.5 MPa or above and 5 MPa or below. By adjusting the pressure in this way, the voids are less likely to occur in the cured resin layer 3. More specifically, by adjusting the pressure to 0.1 MPa or above, the voids may intrinsically be suppressed from generating, and may be collapsed even if they should generate. On the other hand, by adjusting the pressure to 10 MPa or below, the apparatus may be suppressed from being excessively enlarged and complicated. Note that "pressurizing through the fluid" in the context of the present invention means that the pressure of the atmosphere surrounding the stack 4 is elevated from the atmospheric pressure, by an amount of pressure force. For example, a pressure force of 10 MPa means that the stack is applied with a pressure larger by 10 MPa than the atmospheric pressure.

In this embodiment, the stack 4 is placed in the container 51, and the duration from the point of time immediately after the start of heating of the stack 4 (in this embodiment, immediately after the container 51 is closed after placing therein the stack 4), up to the point of time when the temperature of the stack 4 reaches the melting point of the solder layer 112, is set to 5 seconds or longer, and 15 minutes or shorter.
By limiting the duration to 15 minutes or shorter, the first terminals 11 and the second terminals 21 may tightly be bonded. On the other hand, by ensuring the duration of 5 seconds or longer, all of the terminals 11, 21 in the stack 4 may uniformly be fused.
In particular, the duration from the point of time immediately after the start of heating of the stack 4, up to the point of time when the temperature of the stack 4 reaches the melting point of the solder layer 112, is preferably adjusted to 5 seconds or longer and 7 minutes or shorter.
Reason why the bonding between the first terminals 11 and the second terminals 21 may be improved is not fully clarified, but supposed as follows.
In the process of bonding of the first terminals 11 and the second terminals 21, the stack 4 is heated, and the resin layer 3 gradually cures. By adjusting the duration from the point of time immediately after the start of heating of the stack 4, up to the point of time when the temperature of the stack 4 reaches the melting point of the solder layer 112, to 15 minutes or shorter, the oxide film formed on the surface of the solder layer 112 may be removed before the resin layer completely cures, and thereby the bonding between the first terminals 11 and the second terminals 21 may be improved.

As described in the above, after the stack 4 is placed in the container 51, the stack 4 is heated, and concomitantly pressurized.
The fluid for pressurizing the stack 4 is introduced through the pipe 52 into the container 51, and then pressurizes the stack 4. The fluid for pressurizing the stack 4 is preferably a non-oxidative gas such as nitrogen gas or argon gas, or air.
Among them, the non-oxidative gas is preferably used. By using the non-oxidative gas, the bonding between the first terminals 11 and the second terminals 21 may be improved. The non-oxidative gas herein means inert gas and nitrogen gas.
After the temperature of the stack 4 reaches the melting point of the solder layer 112, the stack 4 is heated and pressurized for a predetermined time, while keeping the temperature and pressure of the container 51 unchanged. In this way, the resin layer 3 in the stack 4 cures. By heating and pressurizing the stack 4 in this way, the resin layer 3 may be prevented from generating therein the voids.
In this embodiment, the stack 4 is pressurized with a fluid in the process of bonding of the first terminals 11 and the second terminals 21. The procedure successfuly elevates the density of the resin layer 3 and reduces the volume thereof, and consequently exerts a force in the direction of press contact between the first terminals 11 and the second terminals 21. Pressurizing of the stack 4 with a fluid, in the process of bonding of the first terminals 11 and the second terminals 21, also successfully suppresses fluidization of the resin layer 3 due to foaming thereof, and thereby successfully reduces misalignment between the first terminals 11 and the second terminals 21.

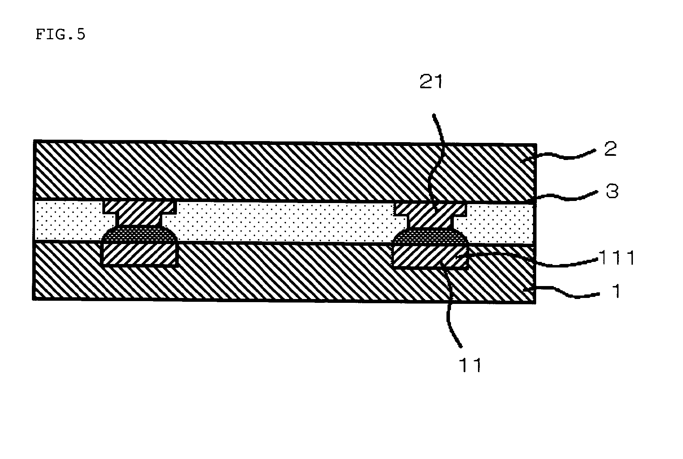

Thereafter, the stack 4 is taken out from the apparatus 5, and cured again if necessary.
The electronic device may be obtained as described in the above (see FIG. 5). As seen in FIG. 5, the first terminals 11 and the second terminals 21 are bonded with the aid of the solder layer 112, while allowing the ends of the second terminals 21 to intrude into the solder layer 112.

### (Second Embodiment)

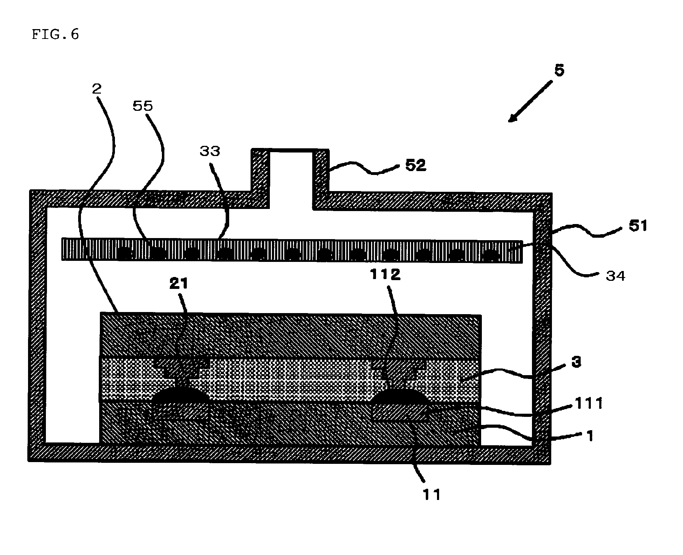

A method of manufacturing an electronic device according to a second embodiment will be outlined, referring to FIG. 6. Also the second embodiment relates to an embodiment according to the first aspect of the invention.

The method of manufacturing an electronic device of this embodiment is similar to the method of manufacturing an electronic device of the first embodiment, except that the stack 4 is heated by radiant heat, in the process of solder bonding of the first terminals 11 and the second terminals 21. Details will be given below.

In the solder bonding of the first terminals 11 and the second terminals 21, the stack 4 is placed in the container 5, and is then heated under pressure using a radiant heat source 33 (see FIG. 6), while allowing a pressurized fluid to flow into the container 51.
Another possible method is to allow the fluid to flow through the pipe 52 into the container 51 so as to prepare a pressurized atmosphere, and then to heat the stack 4 using the radiant heat source 33.

Examples of the radiant heat source 33 include far infrared radiation heater and microwave generator. Heat conduction based on radiant heat relates to emission of electromagnetic wave from an object which serves as a heat source, and absorption of the electromagnetic wave by an object to be heated. Accordingly, heat conduction is ensured irrespective of properties of a medium which resides between the heat source and the object to be heated, in a pressurized atmosphere having a large gas density, or even in vacuum without gas. The radiant heat source is preferably a far infrared radiation heater, in view of simplicity of a mechanism of the apparatus. Examples of materials for composing a radiant 34 of far infrared radiation include ceramic, carbon, stainless steel, nichrome, silicon carbide, tungsten and cesium. Ceramic is thermally and chemically stable, and therefore allows stable process. Ceramic is preferable as the radiant 34, by virtue of its high emission rate. The emission rate herein means a rate of radiant heat of an object, while assuming the emission rate of the black body as a perfect radiant (a physical body capable of absorbing all incident radiant heat in the form of light and electromagnetic wave from the external, and capable of emitting it to the external) as one. Ceramic gives the emission rate in the range from 0.85 to 0.95.
Ceramic may have embedded therein a heating element 55. Alternatively, the heating element 55 may have coated thereon a ceramic as the radiant 34.
The radiant heat source 33 may have a curved geometry or flat geometry. The number of radiant heat sources 33 faced to the stack 4 may be one, or two or more.
In order to accelerate the rate of elevation of temperature of the stack 4, it is effective to preliminarily heat the radiant heat source 33 at a predetermined temperature.

When the stack 4 is placed in the container 51, the distance between the radiant 34 and the stack 4 is preferably adjusted to 60 mm or more and 150 mm or less, and more preferably 60 mm or more and 100 mm or less. By adjusting the distance to the lower limit value or more, heat distribution may be prevented from degrading while being affected by the geometry of conductive heater, and the terminals 11, 12 in the stack 4 may uniformly be fused. On the other hand, by adjusting the distance to the upper limit value or below, the first terminals 11 and the second terminals 21 may tightly be bonded, while ensuring a sufficient amount of energy input per a unit area of the stack 4.
The radiant heat source 33 may be placed so as to oppose the first electronic component 1 of the stack 4, or to oppose the second electronic component 2. Alternatively, the radiant heat source 33 may be placed so as to oppose both of the first electronic component 1 and the second electronic component 2.

By heating with the aid of radiant heat, stable solder bonding may be ensured. The reason is supposed as follows.
In the process of bonding of the first terminals 11 and the second terminals 21, the stack 4 is heated by radiant heat, and the resin layer 3 gradually cures. Radiant heat may directly heat the stack 4, irrespective of a medium which resides between the heat source and the stack 4. By using radiant heat for heating, the stack 4 may be heated in an efficient, rapid, and uniform manner, and thereby the oxide film formed on the surface of the solder layers 112 may be removed by the contribution of the flux-active compound, before the resin layer completely cures. The bonding between the first terminals 11 and the second terminals 21 may be improved as a consequence.

The first aspect of the invention is not limited to the embodiment described in the above, and includes all alterations and modifications so far as they may fulfill the object of the present invention.
For example, while the above-described embodiment adopted the apparatus 5, in which the stack 4 was heated under pressure, and the first terminals 11 and the second terminals 21 were bonded, the present invention is not limited thereto.
For example, a pressure vessel, die (the stack 4 is confined in heated dies just as being clamped by molding dies, but is not brought into contact with the dies), metal box, and glass box are adoptable. For the case where the metal box or glass box is used, the stack 4 may typically be heated under pressure, while being conveyed.
An alternative method of heating of the stack 4 may be such as heating the container *per* se of the apparatus, and circulating the gas using a fan. Still alternatively, the stack 4 may be heated by blowing hot air into the apparatus, and by circulating it.
Still other methods include a heating method based on heating by radiant heat, combined with heating of the container *per se* accompanied by fan-assisted circulation of the gas in the container; and a heating method based on heating by radiant heat, combined with blowing and circulation of hot air in the apparatus.

### (Third Embodiment)

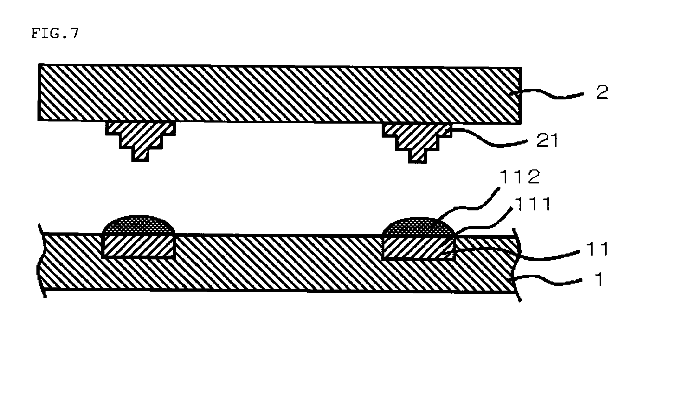

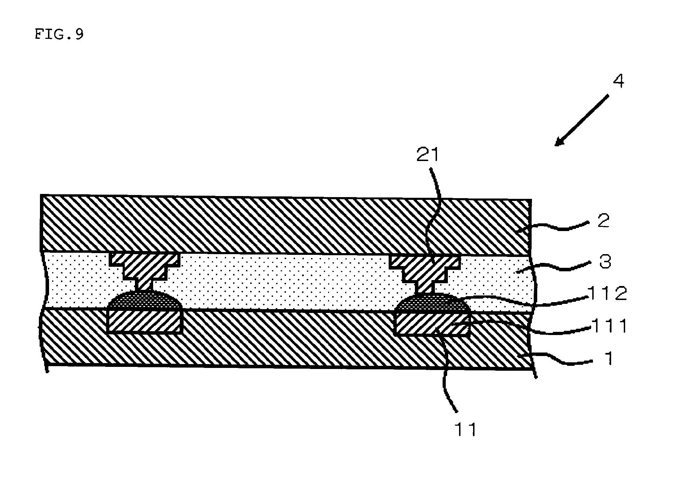

A method of manufacturing an electronic device according to a third embodiment will be outlined, referring to FIGs. 7 to 13. The third embodiment relates to an embodiment according to the second aspect of the invention.
The method of manufacturing an electronic device according to this embodiment is aimed at manufacturing an electronic device which has a first electronic component 1 having first terminals 11 having formed on the surface thereof solder layers 112, and a second electronic component 2 having second terminals 21 to be bonded to the first terminals 11 of the first electronic component 1. The method includes:
obtaining a stack 4 of the first electronic component 1 and the second electronic component 2, while placing between the first terminals 11 and the second terminals 21 a resin layer 3 which contains a flux-active compound and a thermosetting resin;
bonding the first terminals 11 and the second terminals 21 with solder, by heating the stack 4 at a temperature not lower than the melting point of the solder layers 112 on the first terminals 11; and
curing the resin layer 3 while pressurizing the stack 4 using a fluid.
In the process of bonding the first terminals 11 and the second terminals 21 with solder, a plurality of the stacks 4 are prepared, and a member 53 having trenches 531 formed thereon is prepared; then a plurality of areas 532 of the member 53, partitioned by the trenches 531, are brought into contact with the individual stacks 4; and the first terminals 11 and the second terminals 21 are bonded with solder, by heating the individual stacks 4 at a temperature not lower than the melting point of the solder layers 112 on the first terminals 11, while pressurizing the individual stacks 4 in the direction of stacking thereof. In the process of solder bonding, the individual areas 532 of the member 53, partitioned by the trenches 531, are brought into contact with the first electronic components 1 or the second electronic components 2 of the individual stacks 4; and the trenches 531 of the member 53 are concomitantly opposed to gaps which are formed between the components, contained in the adjacent stacks 4, brought into contact with the individual areas 532 partitioned by the trenches 531.

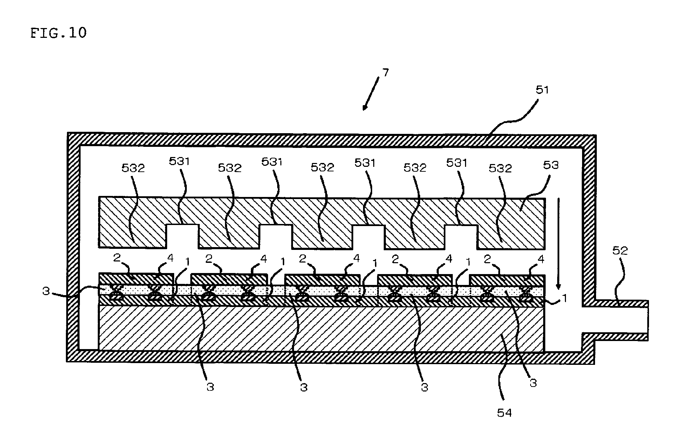

Next, the method of manufacturing an electronic device according to this embodiment will be detailed.
First, as illustrated in FIG. 7, the first electronic component 1 is prepared. The first electronic component 1 adoptable herein may be same as that used in the first embodiment. Also the solder layer 112 adoptable herein may be same as that used in the first embodiment.
Now, as illustrated in FIG. 10, the first electronic component 1 is configured so as to combine a plurality of components. For an exemplary case where each first electronic component 1 is a substrate, the substrates are combined to give a single large substrate. The large substrate have formed thereon dicing lines along which the first electronic components 1 are individualized, as indicated by broken line in FIG. 10.

Next, a second electronic component 2 is prepared (see FIG. 7).
Also the second electronic component 2 adoptable herein may be same as that used in the first embodiment.

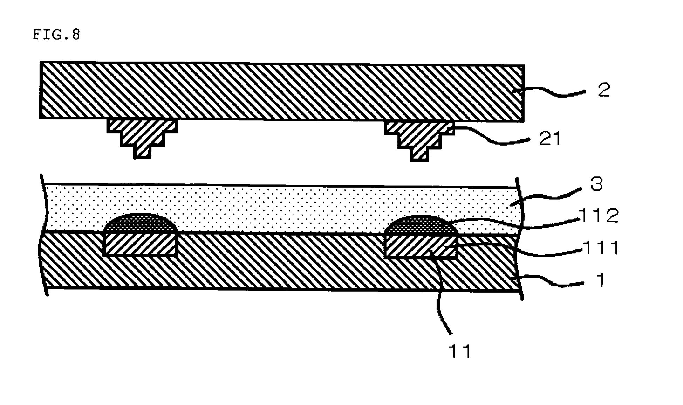

Next, as illustrated in FIG. 8, the resin layer 3 which contains a flux-active compound and a thermosetting resin is placed between the first terminals 11 of the first electronic component 1 and the second terminals 21 of the second electronic component 2, and the first terminals 11 and the second terminals 21 are positionally aligned. Also the placement of the resin layer 3 and the alignment between the first terminals 11 and the second terminals 21 are conducted similarly as described in the first embodiment.

The resin layer 3 adoptable herein may be same as that used in the first embodiment.
Now, as illustrated in FIG. 10, the resin layer 3 is configured to combine a plurality of layers, so as to give a single resin sheet spread over the plurality of first electronic components 1. For more details, the resin sheet is composed of a plurality of resin layers 3, and a connecting portion which connects the plurality of resin layers 3, so that the plurality of resin layers 3 is connected via the connecting portion.

Next, using an apparatus 7 illustrated in FIG. 10, the stacks 4 are heated under pressure, so as to heat the stacks 4 up to a temperature not lower than the melting point of the solder layers 112 on the first terminals 11, and thereby the first terminals 11 and the second terminals 21 are bonded with solder.

The apparatus 7 will be outlined below.
The apparatus 7 is aimed at manufacturing an electronic device which has the first electronic component 1 having the first terminals 11 having formed on the surface thereof solder layers 112, and the second electronic component 2 having the second terminals 21 to be bonded to the first terminals 11 of the first electronic component 1.
The apparatus 7 includes a container 51 in which a plurality of stacks 4 are arranged; a heating unit (not illustrated) heating the stacks 4 in the container 51 up to a temperature not lower than the melting point of the solder layers 112 on the first terminals 11; a pressurized fluid introducing unit 52 introducing a pressurized fluid into the container 51; and a clamping unit clamping the plurality of stacks 4 in the container 51 in the direction of stacking of the stacks 4, and applying load onto the individual stacks 4 in the direction of stacking of the individual stacks.
The clamping unit has the member 53 having the trenches 531 formed thereon. The clamping unit clamps the individual stacks 4, by bringing each of the plurality of areas 532 of the member 53 partitioned by the trenches 531, into contact with each stack 4 in the container 51.
In the process of clamping of the stacks 4, the trenches 531 of the member 53 are opposed to gaps which are formed between the components, contained in the adjacent stacks 4, brought into contact with the individual areas 532 partitioned by the trenches 531. In other words, in this embodiment, the trenches 531 are opposed to the gaps between the adjacent second electronic components 2.

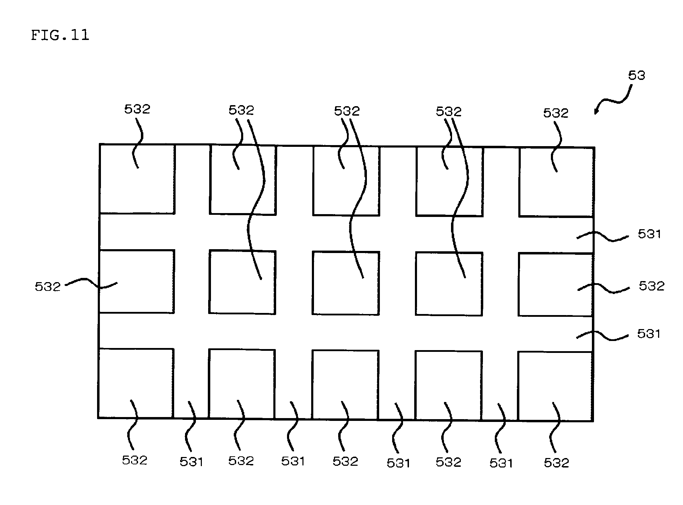

The apparatus 7 will be detailed in the next.
The apparatus 7 is configured to subject therein the stacks 4 to a reflow process and a heating process under a pressurized atmosphere.
The container 51 is a pressure vessel. Materials composing the container 51 include metals, such as stainless steel, titanium and copper.
The container 51 has on the bottom surface thereof a stage 54 on which a plurality of the stacks 4 are placed.
In the adjacent stacks 4, the adjacent first electronic components 1 and the adjacent resin layers 3 are formed so as to be combined with each other, whereas the gaps are formed between the adjacent second electronic components 2.
As illustrated in FIG. 10 and FIG. 11, the member 53 has a plate form, and more specifically a flat rectangular form.
The member 53 may be a metal plate, ceramic plate or the like, without special limitation. Examples of the metal plate include stainless steel plate, titanium plate, and lead plate. Examples of the ceramic plate include glass plate, alumina plate, silicon nitride plate, and zirconia plate.
Note herein that, in order to suppress the heat of the stacks 4 from being absorbed by the member 53, the member 53 is preferably composed of a material having a thermal conductivity of 40 w/m·K or smaller. Examples of the material having a thermal conductivity of 40 w/m·K or smaller include stainless steel plate and glass plate. Among them, the glass plate can uniformly apply load onto the stacks 4, without causing deformation such as bending in the process of heating/cooling, by virtue of its small coefficient of linear expansion.
The member 53 has a plurality of trenches 531 formed thereon, and a part of the trenches 531 cross each other. In this embodiment, the trenches 531 are formed to give a lattice pattern.
The stacks 4 are applied with load through the areas 532 partitioned by the trenches 531. One stack 4 is brought into contact with one area 532.
The member 53 is disposed so that the surface thereof having the trenches 531 formed thereon is opposed to the stage 54.

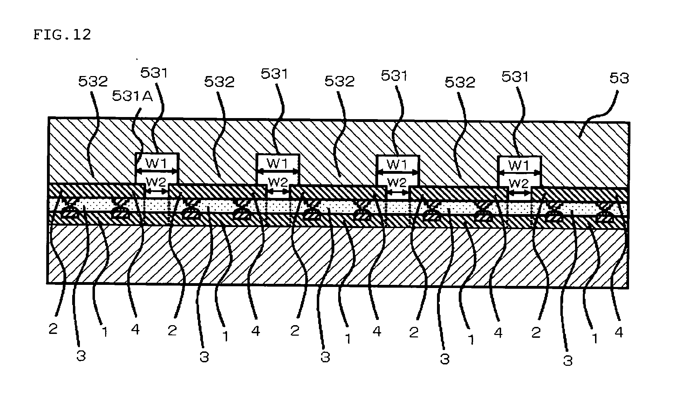

Next, a method of manufacturing the electronic device, using the apparatus 7, will be explained referring to FIG. 10 and FIG. 12.
First, a plurality of stacks 4 are placed on the stage 54 of the container 51.
Next, using an unillustrated conveying unit, the member 53 is brought down towards the bottom side of the container 51, and is placed on the plurality stacks 4. In this way, the plurality of stacks 4 are held between the member 53 and the stage 54, and the individual stacks 4 are applied at least with a load equivalent to the weight of member 53. In other words, the clamping unit described in the above is configured by the member 53 and the stage 54 as a consequence. For the case where the stage is not provided in the container 51, the clamping unit may be configured by the bottom surface of the container 51 and the member 53 as a consequence.
Each stack 4 is now brought into contact with each area 532 partitioned by the trenches 531.
Now, as illustrated in FIG. 12, width W1 of the trenches 531 (length of the trenches 531 in the direction orthogonal to the longitudinal direction thereof) is larger than gap W2 between the adjacent stacks 4. In other words, the end faces of the second electronic components 2, brought into contact with the areas 532 partitioned by the trenches 531, project out from the side faces 531A of the trenches 531 inwards the trenches 531.
Also as described in the above, in the adjacent stacks 4, the adjacent resin layers 3 are formed so as to be combined with each other, whereas the gaps are formed between the adjacent second electronic components 2, so that a part of the resin sheet configured by combining the resin layers 3 exposes in the gaps. The exposed portions of the resin sheet are opposed to the trenches 531.

In this way, the plurality of stacks 4 are held in between and applied with load, and are heated to a temperature not lower than the melting point of the solder layers 112 on the first terminals 11, to thereby bond the first terminals 11 and the second terminals 21 with solder (reflow process).
Since the stacks 4 are applied with load in the direction of stacking, so that the first terminals 11 and the second terminals 21 are kept in contact.
In the process of solder bonding of the first terminals 11 and the second terminals 21, the load to be applied respectively to the first terminals 11 and the second terminals 21 is preferably 0.01 MPa or larger, and 40 MPa or smaller.
By adjusting the load to 0.01 MPa or larger, the distance between the second electronic components 2 and the first electronic components 1 may be kept constant. In addition, the resin layer 3 which resides between the first terminals 11 and the second terminals 21 may be excluded therefrom, and thereby a good connection may be obtained.
On the other hand, by adjusting the load to 40 MPa or smaller, the second electronic components 2 may be prevented from cracking.
Note that the "load to be applied respectively to the first terminals 11 and the second terminals 21" described in the above means the load applied to the first terminals 11 and the second terminals 21, observed when the stacks 4 were applied with a load by the member 53, the second terminals 21 intruded into the solder layers 112 on the first terminals 11, and the distance between the first terminals 11 and the second terminals 21 was stabilized at a constant value.

A possible method of heating the stacks 4 may be such as heating the container 51 *per se* using a heating unit, such as a heater.
Thereafter, the resin layers 3 of the stacks 4 are cured. Note that, even in the reflow process, a part of the resin layer 3 may cure if the temperature of heating is higher than the curing temperature of the resin layer 3.
The stacks 4 are heated by heating the container 51, while feeding a fluid through the pipe 52, provided as the pressurized fluid introducing unit, into the container 51 so as to produce therein a pressurized atmosphere, and the resin layers 3 are cured.
Alternatively, the stacks 4 may be heated and concomitantly be pressurized, by introducing a pressurized fluid into the container 51.

Still alternatively, the reflow process of the stacks 4 and the curing of the resin layers of the stacks 4 may proceed in parallel.
In this case, a pressurized fluid may be introduced into the container 51, while heating the stacks 4 at a temperature not lower than the melting point of the solder layers 112.

Pressure to be applied through the fluid to the stacks 4 is adjusted to 0.1 to 10 MPa, preferably to 0.5 to 5 MPa. By adjusting the pressure in this way, the cured resin layers 3 may be less likely to produce voids therein. Note that, "pressurizing through the fluid" in the context of the present invention means that the pressure of the atmosphere surrounding the stacks 4 is elevated from the atmospheric pressure, by an amount of pressure force. For example, a pressure force of 10 MPa means that the stacks are applied with a pressure larger by 10 MPa than the atmospheric pressure.

The fluid for pressurizing the stacks 4 is fed through the pipe 52 into the container 51, and pressurizes the stacks 4. Also the fluid for pressurizing the stacks 4 adoptable herein may be same as that used in the first embodiment.

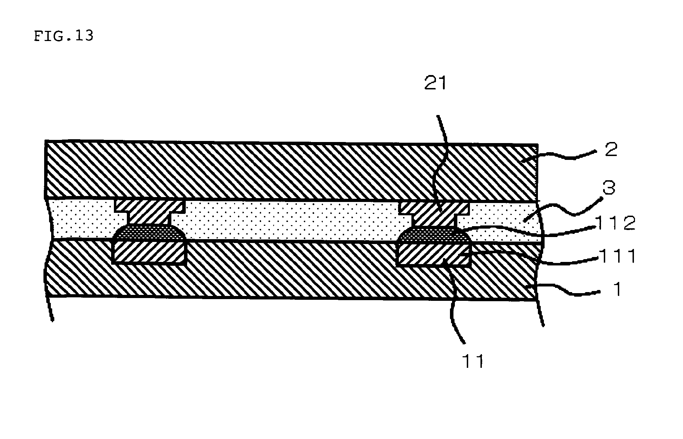

Thereafter, the stacks 4 are taken out from the apparatus 7, and cured again if necessary.
The electronic device may be obtained as described in the above (see FIG. 13). As seen in FIG. 13, the first terminals 11 and the second terminals 21 are bonded with the aid of the solder layers 112, while allowing the ends of the second terminals 21 to intrude into the solder layers 112. A plurality of individualized electronic devices may be obtained by dicing the product, along the dicing lines indicated by broken lines in FIG. 10, between the adjacent first electronic components 1 and the adjacent resin layers 3.

Next, operations and effects of this embodiment will be explained.
In this embodiment, since the plurality of stacks 4 are heated to a temperature not lower than the melting point of the solder layers 112 on the first terminals 11, to thereby proceed solder bonding between the first terminals 11 and the second terminals 21, so that the method ensures a good productivity.
The individual stacks 4 are applied with load, by bringing the member 53, having the trenches 531 formed thereon, into contact with the stacks 4. Accordingly, in the process of bonding of the first terminals 11 and the second terminals 21, the resin and so forth which reside between the first terminals 11 and the second terminals 21 may be excluded, so that wetting of the solder may be improved, and thereby connection failuer may be suppressed.
In addition, by applying the load on the individual stacks 4, while being brought into contact with the member 53 having the trenches 531 formed thereon, any gas possibly generated from the resin run out from the stacks 4 may be leaked into the trenches 531. Accordingly, the resin layers 3 may be prevented from generating therein the voids.
In particular, in this embodiment, the resin layers 3 of the stacks 4 are combined to give a single resin sheet, and a part of the resin sheet exposes from the gap between the adjacent second electronic components 2. In this configuration, the gas may be leaked into the trenches 531, not only when the gas produced from the resin which run out from the stacks 4, but also when the gas produced from the part of the thus-exposed portions of the resin sheet. Accordingly, the resin sheet, and in particular the resin layers 3, may be suppressed from trapping therein the voids.

Since the resin layers 3 in this embodiment are cured while pressurizing the stacks 4 through the pressurized fluid, so that the cured product of the resin layers 3 may be suppressed from generating therein pores or voids. In addition, by pressurizing the stacks 4 through the fluid in the process of solder bonding of the first terminals 11 and the second terminals 21, the resin layers 3 may be increased in the density and decreased in the volume, and thereby a force may be applied in the direction of press contact between the first terminals 11 and the second terminals 21.
In addition, by pressurizing the stacks 4 through the fluid in the process of bonding of the first terminals 11 and the second terminals 21, fluidization of the resin possibly caused by foaming of the resin layers 3 may be suppressed, and thereby misalignment between the first terminals 11 and the second terminals 21 may surely be reduced.

In this embodiment, the member 53 for applying load onto the stacks 4 has formed thereon the trenches 531. While the resin layers 3 in the stacks 4 may sometimes run out from the stacks 4 in the process of bonding of the first terminals 11 and the second terminals 21, the run-out resin layers 3 may be allowed to swell into the trenches 531.
Accordingly, the resin is prevented from intruding between the second electronic components 2 and the member 53.

In this embodiment, the end faces of the second electronic components 2, brought into contact with the areas 532 partitioned by the trenches 531, project out from the side faces 531A of the trenches 531 inwards the trenches 531.
When the stacks 4 are applied with load through the member 53, the resin run out from the stacks 4 may creep up on the end faces of the second electronic components 2 of the stacks 4. Since the side faces 531A of the trenches 531 do not project out from the end faces of the second electronic components 2 inwards the trenches 531, so that the resin will not adhere on the member 53 even if crept up on the end faces of the second electronic component 2. Accordingly, the member 53 may be prevented from being polluted by the resin.

If the member for applying load onto the stacks 4 has no trench formed thereon, the resin run out from the stacks 4 may adhere on the member, to thereby make the member irregular, or degrade the flatness, on the surface thereof opposed to the stacks 4. This may induce non-uniformity of the load to be applied to the stacks 4.
In contrast, according to this embodiment, since the adhesion of the resin onto the member 53 may be prevented, so that the load to be applied to the stacks 4 may be prevented from varying.

Since the stacks 4 in this embodiment are applied with load in the direction of stacking, in the process of solder bonding of the first terminals 11 and the second terminals 21, so that the resin which resides between the first terminals 11 and the second terminals 21 may be excluded, wetting of the solder layers 112 on the first terminals 11 may be improved, and thereby the connection failure may be suppressed.

### (Fourth Embodiment)

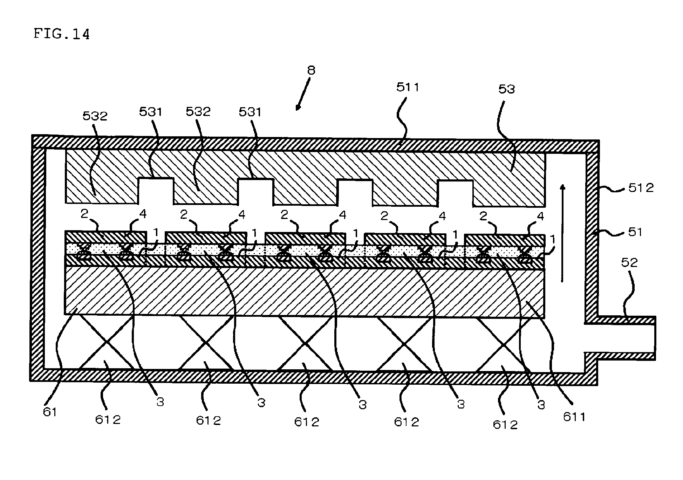

A fourth embodiment will be explained referring to FIG. 14. Also the fourth embodiment relates to an embodiment according to the second aspect of the invention.
The apparatus 7 was used in the foregoing embodiment, in the process of solder bonding of the first terminals 11 and the second terminals 21, and in the process of curing of the resin layers 3. In contrast, this embodiment adopts an apparatus 8 illustrated in FIG. 14.
In the apparatus 7, the member 53 was placed on the stacks 4, so as to hold the stacks 4 between the member 53 and the stage 54. In contrast, the apparatus 8 of this embodiment is configured to press the stacks 4 against the member 53 using a load application unit 61, so as to hold the stacks 4 between the load application unit 61 and the member 53, to thereby apply the load in the direction of stacking of the stacks 4. Other aspects are same as those in the third embodiment.

For more details, the apparatus 8 of this embodiment has the container 51, the pressurized fluid introducing unit 52, and the member 53, which are same as those in the above-described embodiments, and additionally has the load application unit 61.
The container 51 has the member 53 fixed on the ceiling thereof, and thereby the surface of the member 53 having the trenches 531 formed thereon is opposed to a stage 611 described later.
The load application unit 61 has the stage 611 on which a plurality of stacks 4 are placed, and an energizing unit 612 for energizing the stage 611 towards the member 53.
The stage 611 is provided for placement of a plurality of the stacks 4, and is typically a plate member. On the stage 611, a plurality of stacks 4 are placed.
The energizing unit 612 is arranged on the back side of the stage 611. The energizing unit 612 is typically a spring, and presses the stacks 4 on the stage 611 against the member 53 to thereby apply load to the stacks 4. Similarly as described in the foregoing embodiments, one stack 4 is brought into contact with one area 532. Since the stacks 4 in this embodiment are held between the load application unit 61 and the member 53, it is understood that a clamping unit is configured by the load application unit 61 and the member 53.
When the stacks 4 are pressed against the areas 532 of the member 53, the gaps between the second electronic components 2 of the adjacent stacks 4 are opposed to the trenches 531 of the member 53. In other words, the portions of the resin sheet exposed in the gaps between the second electronic components 2 of the adjacent stacks are opposed to the trenches 531 of the member.

In this embodiment, the container 51 is composed of an upper die 511 and a lower die 512, wherein the upper die 511 is heated at a temperature not lower than the melting point of the solder layers 112. Also the lower die 512 is heated to a predetermined temperature, typically at 50°C or around.
Since the member 53 in this embodiment is composed of a metal member having a large thermal conductivity, heat of the upper die 511 conducts through the member 53 to the stacks 4, and thereby the stacks 4 are heated. The member 53 may be heated up to a temperature equivalent to that of the upper die 511.

A method of manufacturing the electronic device using the apparatus 8 will be described in the next.
First, on the stage 611 of the container 51, a plurality of the stacks 4 are placed.
At this point of time, the stage 611 and the member 53 are spaced from each other, by suppressing the action of the energizing unit 612 using an unillustrated disenergizing unit.
Next, the disenergizing unit is inactivated so as to allow the energizing unit 612 to move the stage 611 upward, to thereby bring the plurality of stacks 4 into contact with the member 53, and to concomitantly apply the load on the plurality of stacks 4. In this process, the one stack 4 is brought into contact with one area 532 partitioned by the trenches 531.
Now, similarly as described in the foregoing embodiments, the width of the trenches 531 (length of the trenches 531 in the direction orthogonal to the longitudinal direction thereof) is larger than the gap between the adjacent stacks 4. In other words, the end faces of the second electronic components 2, brought into contact with the areas 532 partitioned by the trenches 531, project out from the side faces 531A of the trenches 531 inwards the trenches 531.

While keeping the plurality of stacks 4 under load in this way, the individual stacks 4 are heated to a temperature not lower than the melting point of the solder layers 112 on the first terminals 11, to thereby bond the first terminals 11 and the second terminals 21 with solder (reflow process).
In the process of solder bonding of the first terminals 11 and the second terminals 21, the load to be applied respectively to the first terminals 11 and the second terminals 21 is preferably 0.01 MPa or larger, and 40 MPa or smaller.
By adjusting the load to 0.01 MPa or larger, the distance between the second electronic components 2 and the first electronic components 1 may be kept constant. In addition, the resin layers 3 which reside between the first terminals 11 and the second terminals 21 may be excluded therefrom, and thereby a good connection may be obtained.
On the other hand, by adjusting the load to 40 MPa or smaller, the second electronic components 2 may be prevented from cracking.
Other process are similar to those in the embodiment. Note that, similarly as described in the foregoing embodiments, the reflow process and the curing process of the resin layers 3 may proceed in parallel.

According to this embodiment, effects similar to those in the third embodiment may be obtained.
In addition, according to this embodiment, the stacks 4 may rapidly be heated, since the stacks 4 are pressed against the heated member 53 having a large thermal conductivity. Since the member 53 is fixed to the heated upper die 511, the member 53 may be prevented from dissipating the heat.

The second aspect of the invention is not limited to the embodiment described in the above, and includes all alterations and modifications so far as they may fulfill the object of the present invention.
For example, while the member 53 in the fourth embodiment was attached to the upper die 511, the member 53 may be integrated with the upper die 511 if the trenches may be formed in the upper die 511.
While the stacks 4 in the fourth embodiment were pressed against the heated member 53, the heated member 53 may alternatively be brought down to be pressed against the stacks 4. Note that it is necessary to prevent the member 53 in this case from dissipating the heat.
While, in the foregoing embodiments, a plurality of the first electronic components 1, and a plurality of the resin layers 3 were combined, the present invention is not limited thereto. For example, the first electronic components 1 and the resin layers 3 may preliminarily be separated, having the gaps formed between the first electronic components 1, and between the resin layers 3.
While, in the foregoing embodiments, the member 53 was brought into contact with the second electronic components 2, the present invention is not limited thereto. The member 53 may be brought into contact with the first electronic components 1.
Still alternatively, the member 53 may be brought into contact with the first electronic component 1 in one stack 4, and with the second electronic component 2 in another stack 4. However, from the viewpoint of stability of bonding between the terminals, the component brought into contact with the member 53 is preferably all the same, as described in the foregoing embodiments.

### [Examples]

Next, Examples according to the first embodiment of the invention will be explained.

### (Example A1)

### (Formation of Filmy Resin Layer 3)

Fifteen parts by weight of phenolphthalein (from Tokyo Chemical Industry Co., Ltd.) as the flux-active compound, 15 parts by weight of PR-53467 (from Sumitomo Bakelite Co., Ltd.) as the phenolic novolac resin, 50 parts by weight of EOCN-1020-70 (from Nippon Kayaku Co., Ltd.) as the epoxy resin, 20 parts by weight of YP-50 (from Tohto Kasei Co., Ltd.) as the phenoxy resin, 1.0 parts by weight of KBM-303 (from Shin-Etsu Chemical Co., Ltd.) as the silane coupling agent, and 0.1 parts by weight of 2P4MZ (from Shikoku Chemicals Corporation) as the imidazole compound were dissolved in acetone, to thereby prepare a varnish-like resin composition.
The varnish-like resin composition obtained in the above was coated using a comma coater over a polyester sheet (base), dried at 100°C, at which acetone vaporizes, for 3 minutes, to thereby obtain the filmy resin layer 3 of 25 µm thick formed on the base.

### (Manufacturing of Electronic Device)

The filmy resin layer 3 formed on the base was laminated over the surface of a circuit substrate (first electronic component 1), having solder bumps (solder layer 112) formed thereon, using a vacuum laminator at 100°C under a pressure of 0.7 MPa. The base was then separated.
Next, the first terminals 11 of the circuit substrate and the second terminals 21 of the semiconductor chip (second electronic component 2) were opposed and positionally aligned, and compressed using a flip-chip bonder under heating at 80°C, 0.05 MPa, for 7 seconds, to thereby produce the stack 4.
The stack 4 was then placed in the container 51 of the apparatus 5 preheated at 100°C. A fluid (air) was fed into the container 51, the atmosphere was pressurized at 0.5 MPa, and the stack 4 was heated up to the melting point of the solder layer 112. The duration from the start of heating of the stack 4 (the point of time when the opening of the container 51, through which the stack 4 was brought, was closed after the placement of the stack 4), up to the point of time when the temperature of the stack 4 reached the melting point of solder (225°C), was set to 15 minutes.
The pressure applicable through the fluid was adjusted to 0.5 MPa, while keeping the stack 4 in the container 51, the temperature was lowered to 180°C, and the stack 4 was heated under pressure for 60 minutes.
The container 51 used herein measured approximately 200 mm wide, approximately 10 mm high, and approximately 100 mm deep.

### (Evaluation of Electronic Device)

The electronic device obtained in Example A1 was evaluated as follows.

### 1. Measurement of Electrical Connection and Observation of Bonding Geometry

On the thus-obtained electronic devices, a pair of adjacent solder-connected portions were arbitrarily selected, and connection resistance therebetween was measured using a digital multimeter. Pairs of adjacent solder-connected points were then arbitrarily selected at nine additional sites, and the contact resistance was similarly measured. The electrical connection was therefore measured at 10 sites in total.
Next, the thus-obtained electronic device was cut, the section of the cured product was polished, and the solder-connected portions, for which the electrical connection has been measured, were observed under a metallurgical microscope. A good bonding geometry herein means that the solder-connected portion gives a curved sectional geometry enough to confirm wetting by the solder. If the wetting by the solder is insufficient, the sectional geometry will be notched, rather than curved.
Marks represent as follows:
A: electrical connection confirmed at every of 10 sites, without notch in sectional geometry of bonding;
B: electrical connection confirmed at every of 10 sites, showing notch in sectional geometry of bonding at 1 to 9 sites;
C: electrical connection confirmed at every of 10 sites, showing notch in sectional geometry of bonding in all of 10 sites; and
D: electrical connection failure confirmed even at a single site.
The samples given with the marks A, B and C are of no practical problem, whereas the samples given with the mark D are not suitable for practical use.

### 2. Occurrence of Microvoids in Resin Layer

The obtained electronic device was cut, and the section of the resin layer was polished. Next, portions surrounded by the first electronic component, the second electronic component and two adjacent solder-connected portions were arbitrarily selected at 10 sites, and occurrence of microvoids in the individual portions was observed under the metallurgical microscope. Marks represent as follows:
○: no microvoids observed at every of 10 sites; and
×: microvoids observed even at a single site.

### (Example A2)

### (Manufacturing and Evaluation of Electronic Device)

An electronic device was manufactured, and then evaluated similarly as described in Example A1, except that the amount of addition of imidazole compound 2P4MZ (from Shikoku Chemicals Corporation) was reduced from 0.1 parts by weight down to 0.05 parts by weight.

### (Example A3)

### (Manufacturing and Evaluation of Electronic Device)

An electronic device was manufactured, and then evaluated similarly as described in Example 1, except that the amount of addition of imidazole compound 2P4MZ (from Shikoku Chemicals Corporation) was reduced from 0.1 parts by weight down to 0.025 parts by weight.

### (Example A4)

### (Manufacturing and Evaluation of Electronic Device)

Fifteen parts by weight of phenolphthalein (from Tokyo Chemical Industry Co., Ltd.) as the flux-active compound, 15 parts by weight of PR-53467 (from Sumitomo Bakelite Co., Ltd.) as the phenolic novolac resin, 45 parts by weight of EOCN-1020-70 (from Nippon Kayaku Co., Ltd.) as the epoxy resin, 15 parts by weight of YP-50 (from Tohto Kasei Co. , Ltd.) as the phenoxy resin, 1.0 parts by weight of KBM-303 (from Shin-Etsu Chemical Co., Ltd.) as the silane coupling agent, 0.05 parts by weight of 2P4MZ (from Shikoku Chemicals Corporation) as the imidazole compound, and SO1050-LC (from Admatechs Co., Ltd.) as the inorganic filler were dissolved into acetone, to thereby prepare a varnish-like resin composition.
Next, the resin layer 3 was formed similarly as described in Example A1, and the electronic device was further manufactured an evaluated.

### (Example A5)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A1, except that the duration from the start of heating of the stack 4 up to when the melting point of solder (225°C) is reached was set to 7 minutes.

### (Example A6)

### (Formation of Filmy Resin Layer)

The resin layer 3 was formed similarly as described in Example A2.

### (Manufacturing and Evaluation of Electronic Device)

An electronic device was manufactured and evaluated similarly as described in Example A5.

### (Example A7)

### (Formation of Filmy Resin Layer)

The resin layer 3 was formed similarly as described in Example A3.

### (Manufacturing and Evaluation of Electronic Device)

An electronic device was manufactured and evaluated similarly as described in Example A5.

### (Example A8)

### (Formation of Filmy Resin Layer)

The resin layer 3 was formed similarly as described in Example A4.

### (Manufacturing and Evaluation of Electronic Device)

An electronic device was manufactured and evaluated similarly as described in Example A5.

### (Example A9)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A1, except that the duration from the start of heating of the stack 4 up to when the melting point of solder (225°C) is reached was set to 5 seconds.

### (Example A10)

### (Formation of Filmy Resin Layer)

The resin layer 3 was formed similarly as described in Example A2.

### (Manufacturing and Evaluation of Electronic Device)

An electronic device was manufactured and evaluated similarly as described in Example A9.

### (Example A11)

### (Formation of Filmy Resin Layer)

The resin layer 3 was formed similarly as described in Example A3.

### (Manufacturing and Evaluation of Electronic Device)

An electronic device was manufactured and evaluated similarly as described in Example A9.

### (Example A12)

### (Formation of Filmy Resin Layer)

The resin layer 3 was formed similarly as described in Example A4.

### (Manufacturing and Evaluation of Electronic Device)

An electronic device was manufactured and evaluated similarly as described in Example A9.

### (Example A13)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A1, except that nitrogen was used in place of air, as the fluid to be fed into the container 51.

### (Example A14)

### (Formation of Filmy Resin Layer)

The resin layer 3 was formed similarly as described in Example A2.

### (Manufacturing and Evaluation of Electronic Device)

An electronic device was manufactured and evaluated similarly as described in Example A13.

### (Example A15)

The resin layer 3 was formed similarly as described in Example A3.

### (Manufacturing and Evaluation of Electronic Device)

An electronic device was manufactured and evaluated similarly as described in Example A13.

### (Example A16)

### (Formation of Filmy Resin Layer)

The resin layer 3 was formed similarly as described in Example A4.

### (Manufacturing and Evaluation of Electronic Device)

An electronic device was manufactured and evaluated similarly as described in Example A13.

### (Example A17)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A5, except that nitrogen was used in place of air, as the fluid to be fed into the container 51.

### (Example A18)

The resin layer 3 was formed similarly as described in Example A2.

### (Manufacturing and Evaluation of Electronic Device)

An electronic device was manufactured and evaluated similarly as described in Example A17.

### (Example A19)

### (Formation of Filmy Resin Layer)

The resin layer 3 was formed similarly as described in Example A3.

### (Manufacturing and Evaluation of Electronic Device)

An electronic device was manufactured and evaluated similarly as described in Example A17.

### (Example A20)

### (Formation of Filmy Resin Layer)

The resin layer 3 was formed similarly as described in Example A4.

### (Manufacturing and Evaluation of Electronic Device)

An electronic device was manufactured and evaluated similarly as described in Example A17.

### (Example A21)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A9, except that nitrogen was used in place of air, as the fluid to be fed into the container 51.

### (Example A22)

### (Formation of Filmy Resin Layer)

The resin layer 3 was formed similarly as described in Example A2.

### (Manufacturing and Evaluation of Electronic Device)

An electronic device was manufactured and evaluated similarly as described in Example A21.

### (Example A23)

### (Formation of Filmy Resin Layer)

The resin layer 3 was formed similarly as described in Example A3.

### (Manufacturing and Evaluation of Electronic Device)

An electronic device was manufactured and evaluated similarly as described in Example A21.

### (Example A24)

### (Formation of Filmy Resin Layer)

The resin layer 3 was formed similarly as described in Example A4.

### (Manufacturing and Evaluation of Electronic Device)

An electronic device was manufactured and evaluated similarly as described in Example A21.

### (Example A25)

An electronic device was manufactured similarly as described in Example A17, except that the pressure to be applied to the stack 4 was adjusted to 0.3 MPa.

### (Example A26)

An electronic device was manufactured similarly as described in Example A17, except that the pressure to be applied to the stack 4 was adjusted to 0.8 MPa.

### (Example A27)

An electronic device was manufactured similarly as described in Example A21, except that the pressure to be applied to the stack 4 was adjusted to 0.3 MPa.

### (Example A28)

An electronic device was manufactured similarly as described in Example A21, except that the pressure to be applied to the stack 4 was adjusted to 0.8 MPa.

### (Example A29)

### (Formation of Filmy Resin Layer)

Thirteen parts by weight of phenolphthalein (from Tokyo Chemical Industry Co., Ltd.) as the flux-active compound, 13 parts by weight of PR-53467 (from Sumitomo Bakelite Co., Ltd.) as the phenolic novolac resin, 45 parts by weight of EOCN-1020-70 (from Nippon Kayaku Co., Ltd.) as the epoxy resin, 18 parts by weight of YP-50 (from Tohto Kasei Co., Ltd.) as the phenoxy resin, 0.9 parts by weight of KBM-303 (from Shin-Etsu Chemical Co. , Ltd.) as the silane coupling agent, 0.1 parts by weight of 2P4MZ (from Shikoku Chemicals Corporation) as the imidazole compound, and 10 parts by weight of SO1050-LC (from Admatechs Co., Ltd.) as the inorganic filler were dissolved into acetone, and thereby a varnish-like resin composition was prepared.
Next, the resin layer 3 was formed similarly as described in Example A1.

### (Manufacturing and Evaluation of Electronic Device)

An electronic device was manufactured and evaluated similarly as described in Example A17.

### (Example A30)

### (Formation of Filmy Resin Layer)

Ten parts by weight of phenolphthalein (from Tokyo Chemical Industry Co., Ltd.) as the flux-active compound, 10.2 parts by weight of PR-53467 (from Sumitomo Bakelite Co., Ltd.) as the phenolic novolac resin, 35 parts by weight of EOCN-1020-70 (from Nippon Kayaku Co., Ltd.) as the epoxy resin, 14 parts by weight of YP-50 (from Tohto Kasei Co., Ltd.) as the phenoxy resin, 0. 7 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 30 parts by weight of SO1050-LC (from Admatechs Co., Ltd.) as the inorganic filler were dissolved into acetone, to thereby prepare a varnish-like resin composition.

Next, the resin layer 3 was formed similarly as described in Example A1.

### (Manufacturing and Evaluation of Electronic Device)

An electronic device was manufactured and evaluated similarly as described in Example A17.

### (Example A31)

### (Formation of Filmy Resin Layer)

6.2 Parts by weight of phenolphthalein (from Tokyo Chemical Industry Co., Ltd.) as the flux-active compound, 6. 25 parts by weight of PR-53467 (from Sumitomo Bakelite Co., Ltd.) as the phenolic novolac resin, 21 parts by weight of EOCN-1020-70 (from Nippon Kayaku Co., Ltd.) as the epoxy resin, 11 parts by weight of YP-50 (from Tohto Kasei Co. , Ltd.) as the phenoxy resin, 0. 45 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 55 parts by weight of SO1050-LC (from Admatechs Co., Ltd.) as the inorganic filler were dissolved into acetone, to thereby prepare a varnish-like resin composition.
Next, the resin layer 3 was formed similarly as described in Example A1.

### (Manufacturing and Evaluation of Electronic Device)

An electronic device was manufactured and evaluated similarly as described in Example A17.

### (Example A32)

### (Formation of Filmy Resin Layer)

3.5 Parts by weight of phenolphthalein (from Tokyo Chemical Industry Co., Ltd.) as the flux-active compound, 2.55 parts by weight of PR-53467 (from Sumitomo Bakelite Co., Ltd.) as the phenolic novolac resin, 13.6 parts by weight of EOCN-1020-70 (from Nippon Kayaku Co. , Ltd.) as the epoxy resin, 5 parts by weight of YP-50 (from Tohto Kasei Co., Ltd.) as the phenoxy resin, 0.25 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 75 parts by weight of SO1050-LC (from Admatechs Co., Ltd.) as the inorganic filler were dissolved into acetone, to thereby prepare a varnish-like resin composition.
Next, the resin layer 3 was formed similarly as described in Example A1.

### (Manufacturing and Evaluation of Electronic Device)

An electronic device was manufactured and evaluated similarly as described in Example A17.

### (Example A33)

### (Formation of Filmy Resin Layer)

Fifteen parts by weight of phenolphthalein (from Tokyo Chemical Industry Co., Ltd.) as the flux-active compound, 15 parts by weight of VR-9305 (fromMitsui Chemical, Inc.) as the phenolic novolac resin, 50 parts by weight of EPICLON 840-S (from DIC Corporation) as the epoxy resin, 20 parts by weight of YX-8100 (from Japan Epoxy Resin Co., Ltd.) as the phenoxy resin, 1.0 parts by weight of KBM-303 (from Shin-Etsu Chemical Co., Ltd.) as the silane coupling agent, and 0.1 parts by weight of 2P4MZ (from Shikoku Chemicals Corporation) as the imidazole compound were dissolved into acetone, to thereby prepare a varnish-like resin composition.
Next, the resin layer 3 was formed similarly as described in Example A1.

### (Manufacturing and Evaluation of Electronic Device)

An electronic device was manufactured and evaluated similarly as described in Example A17.

### (Example A34)

### (Formation of Filmy Resin Layer)

Thirteen parts by weight of phenolphthalein (from Tokyo Chemical Industry Co., Ltd.) as the flux-active compound, 13 parts by weight of VR-9305 (from Mitsui Chemical, Inc.) as the phenolic novolac resin, 45 parts by weight of EPICLON 840-S (from DIC Corporation) as the epoxy resin, 18 parts by weight of YX-8100 (from Japan Epoxy Resin Co., Ltd.) as the phenoxy resin, 0. 9 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 10 parts by weight of SO1050-LC (from Admatechs Co., Ltd.) as the inorganic filler were dissolved into acetone, to thereby prepare a varnish-like resin composition.
Next, the resin layer 3 was formed similarly as described in Example A1.

### (Manufacturing and Evaluation of Electronic Device)

The electronic device was manufactured and evaluated similarly as described in Example A33.

### (Example A35)

### (Formation of Filmy Resin Layer)

Ten parts by weight of phenolphthalein (from Tokyo Chemical Industry Co., Ltd.) as the flux-active compound, 10.2 parts by weight of VR-9305 (from Mitsui Chemical, Inc.) as the phenolic novolac resin, 35 parts by weight of EPICLON 840-S (from DIC Corporation) as the epoxy resin, 14 parts by weight of YX-8100 (from Japan Epoxy Resin Co., Ltd.) as the phenoxy resin, 0.7 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 30 parts by weight of SO1050- (from Admatechs Co., Ltd.) as the inorganic filler were dissolved into acetone, to thereby prepare a varnish-like resin composition.
Next, the resin layer 3 was formed similarly as described in Example A1.

### (Manufacturing and Evaluation of Electronic Device)

The electronic device was manufactured and evaluated similarly as described in Example A33.

### (Example A36)

### (Formation of Filmy Resin Layer)

6.2 Parts by weight of phenolphthalein (from Tokyo Chemical Industry Co. , Ltd.) as the flux-active compound, 6.25 parts by weight of VR-9305 (from Mitsui Chemical, Inc.) as the phenolic novolac resin, 21 parts by weight of EPICLON 840-S (from DIC Corporation) as the epoxy resin, 11 parts by weight of YX-8100 (from Japan Epoxy Resin Co., Ltd.) as the phenoxy resin, 0.45 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 55 parts by weight of SO1050-LC (from Admatechs Co., Ltd.) as the inorganic filler, were dissolved into acetone, to thereby prepare a varnish-like resin composition.
Next, the resin layer 3 was formed similarly as described in Example A1.

### (Manufacturing and Evaluation of Electronic Device)

The electronic device was manufactured and evaluated similarly as described in Example A33.

### (Example A37)

### (Formation of Filmy Resin Layer)

3.5 Parts by weight of phenolphthalein (from Tokyo Chemical Industry Co., Ltd.) as the flux-active compound, 2.55 parts by weight of VR-9305 (from Mitsui Chemical, Inc.) as the phenolic novolac resin, 13.6 parts by weight of EPICLON 840-S (from DIC Corporation) as the epoxy resin, 5 parts by weight of YX-8100 (from Japan Epoxy Resin Co., Ltd.) as the phenoxy resin, 0.25 parts by weight of KBM-303 (from Shin-Etsu Chemical Co., Ltd.) as the silane coupling agent, 0.1 parts by weight of 2P4MZ (from Shikoku Chemicals Corporation) as the imidazole compound, and 75 parts by weight of SO1050-LC (from Admatechs Co., Ltd.) as the inorganic filler were dissolved into acetone, to thereby prepare a varnish-like resin composition.
Next, the resin layer 3 was formed similarly as described in Example A1.

### (Manufacturing and Evaluation of Electronic Device)

The electronic device was manufactured and evaluated similarly as described in Example A33.

### (Example A38)

### (Preparation of Pasty Thermosetting Resin Composition)

3.55 Parts by weight of phenolphthalein (from Tokyo Chemical Industry Co., Ltd.) as the flux-active compound, 5. 33 parts by weight of PR-51470 (from Sumitomo Bakelite Co., Ltd.) and 5. 33 parts by weight of MEH-8000 (from Toshiba Chemical Corporation) as the phenolic novolac resin, 35.45 parts by weight of EXA-830LVP (from DIC Corporation) as the epoxy resin, 0.35 parts by weight of 2P4MZ (from Shikoku Chemicals Corporation) as the imidazole compound, and 50 parts by weight of SO1050-LC (from Admatechs Co., Ltd.) as the inorganic filler were dispersed and kneaded using a three-roll mill, and defoamed *in vacuo,* to thereby obtain a pasty thermosetting resin composition.

### (Manufacturing and Evaluation of Electronic Device)

The pasty resin composition was coated over the surface of a circuit substrate (first electronic component 1), having solder bumps (solder layer 112) formed thereon, using a dispenser. Next, the first terminals 11 of the circuit substrate and the second terminals 21 of the semiconductor chip (second electronic component 2) were opposed and positionally aligned, and compressed using a flip-chip bonder under heating at 80°C, 0.05 MPa, for 7 seconds, to thereby produce the stack 4.
The stack 4 was then placed in the container 51 of the apparatus 5 preheated at 100°C. A fluid (nitrogen) was fed into the container 51, the atmosphere was pressurized at 0.5 MPa, and the stack 4 was heated up to the melting point of the solder layer 112. The duration from the start of heating of the stack 4 (the point of time when the opening of the container 51, through which the stack 4 was brought, was closed after the placement of the stack 4), up to the point of time when the temperature of the stack 4 reached the melting point of solder (225°C), was set to 7 minutes.
The pressure applicable through the fluid was adjusted to 0.5 MPa, while keeping the stack 4 in the container 51, the temperature was lowered to 150°C, and the stack 4 was heated under pressure for 120 minutes.
The container 51 used herein measured approximately 200 mm wide, approximately 10 mm high, and approximately 100 mm deep.
Next, the electronic device was evaluated similarly as described in Example A1.

### (Example A39)

### (Preparation of Pasty Thermosetting Resin Composition)

3.55 Parts by weight of phenolphthalein (from Tokyo Chemical Industry Co. , Ltd.) as the flux-active compound, 5. 33 parts by weight of PR-51470 (from Sumitomo Bakelite Co., Ltd.) and 5.33 parts by weight of MEH-8000 (from Toshiba Chemical Corporation) as the phenolic novolac resin, 35.45 parts by weight of EXA-830LVP (from DIC Corporation) as the epoxy resin, 0.18 parts by weight of 2P4MZ (from Shikoku Chemicals Corporation) as the imidazole compound, and 50 parts by weight of SO1050-LC (from Admatechs Co., Ltd.) as the inorganic filler were dispersed and kneaded using a three-roll mill, and defoamed *in vacuo,* to thereby obtain a pasty thermosetting resin composition.

### (Manufacturing and Evaluation of Electronic Device)

The electronic device was manufactured and evaluated similarly as described in Example A38.

### (Example A40)

### (Preparation of Pasty Thermosetting Resin Composition)

3.55 Parts by weight of phenolphthalein (from Tokyo Chemical Industry Co., Ltd.) as the flux-active compound, 5. 33 parts by weight of PR-51470 (from Sumitomo Bakelite Co., Ltd.) and 5.33 parts by weight of MEH-8000 (from Toshiba Chemical Corporation) as the phenolic novolac resin, 35.45 parts by weight of EXA-830LVP (from DIC Corporation) as the epoxy resin, 0.088 parts by weight of 2P4MZ (from Shikoku Chemicals Corporation) as the imidazole compound, and 50 parts by weight of SO1050-LC (from Admatechs Co., Ltd.) as the inorganic filler were dispersed and kneaded using a three-roll mill, and defoamed *in vacuo,* to thereby obtain a pasty thermosetting resin composition.

### (Manufacturing and Evaluation of Electronic Device)

The electronic device was manufactured and evaluated similarly as described in Example A38.

### (Example A41)

### (Preparation of Pasty Thermosetting Resin Composition)

4.97 Parts by weight of phenolphthalein (from Tokyo Chemical Industry Co. , Ltd.) as the flux-active compound, 7.46 parts by weight of PR-51470 (from Sumitomo Bakelite Co., Ltd.) and 7.46 parts by weight of MEH-8000 (from Toshiba Chemical Corporation) as the phenolic novolac resin, 49.63 parts by weight of EXA-830LVP (from DIC Corporation) as the epoxy resin, 0.49 parts by weight of 2P4MZ (from Shikoku Chemicals Corporation) as the imidazole compound, and 30 parts by weight of SO1050-LC (from Admatechs Co., Ltd.) as the inorganic filler were dispersed and kneaded using a three-roll mill, and defoamed *in vacuo,* to thereby obtain a pasty thermosetting resin composition.

### (Manufacturing and Evaluation of Electronic Device)

The electronic device was manufactured and evaluated similarly as described in Example A38.

### (Example A42)

### (Preparation of Pasty Thermosetting Resin Composition)

2.13 Parts by weight of phenolphthalein (from Tokyo Chemical Industry Co., Ltd.) as the flux-active compound, 3.20 parts by weight of PR-51470 (from Sumitomo Bakelite Co., Ltd.) and 3.20 parts by weight of MEH-8000 (from Toshiba Chemical Corporation) as the phenolic novolac resin, 21.27 parts by weight of EXA-830LVP (from DIC Corporation) as the epoxy resin, 0.21 parts by weight of 2P4MZ (from Shikoku Chemicals Corporation) as the imidazole compound, and 70 parts by weight of SO1050-LC (from Admatechs Co., Ltd.) as the inorganic filler were dispersed and kneaded using a three-roll mill, and defoamed *in vacuo,* to thereby obtain a pasty thermosetting resin composition.

### (Manufacturing and Evaluation of Electronic Device)

The electronic device was manufactured and evaluated similarly as described in Example A38.

### (Example B1)

### (Formation of Filmy Resin Layer 3)

The resin layer 3 was formed similarly as described in Example A1.

### (Manufacturing of Electronic Device)

An electronic device was manufactured according to a method of the second embodiment.
Specific procedures are as follows. The filmy resin layer 3 formed on the base was laminated over the surface of a circuit substrate (first electronic component 1), having solder bumps (solder layer 112) formed thereon, using a vacuum laminator at 100°C under a pressure of 0.7 MPa. The base was then separated.
Next, the first terminals 11 of the circuit substrate and the second terminals 21 of the semiconductor chip (second electronic component 2) were opposed and positionally aligned, and compressed using a flip-chip bonder under heating at 80°C, 0.05 MPa, for 7 seconds, to thereby produce the stack 4.
The radiant heat source 53 used herein was a far infrared radiation heater which uses a ceramic radiant having a conductive heater embedded therein. The radiant heat source 53 was preliminarily heated to 240°C, at a position not opposing to the stack 4. The container 51 was fed with a fluid (air), pressurized at 0.5 MPa, and the radiant heat source 53 was moved to the position opposing to the second electronic component 2 of the stack 4, and the stack 4 was then heated up to the melting point of the solder layer 112. The distance between the stack 4 and the radiant heat source 53 was adjusted to 150 mm. The duration from the start of heating of the stack 4 (the point of time when the opening of the container 51, through which the stack 4 was brought, was closed after the placement of the stack 4), up to the point of time when the temperature of the stack 4 reached the melting point of solder (225°C), was set to 15 minutes.
The pressure applicable through the fluid was adjusted to 0.5 MPa, while keeping the stack 4 in the container 51, the temperature was lowered to 180°C, and the stack 4 was heated under pressure for 60 minutes.

### (Evaluation of Electronic Device)

The electronic device was evaluated similarly as described in Example A1.

### (Example B2)

### (Manufacturing and Evaluation of Electronic Device)

An electronic device was manufactured similarly as described in Example B1, except that the amount of addition of the imidazole compound 2P4MZ (from Shikoku Chemical Corporation) was reduced from 0.1 parts by weight down to 0.05 parts by weight.

### (Example B3)

### (Manufacturing and Evaluation of Electronic Device)

An electronic device was manufactured similarly as described in Example B1, except that the amount of addition of the imidazole compound 2P4MZ (from Shikoku Chemical Corporation) was reduced from 0.1 parts by weight down to 0.025 parts by weight.

### (Example B4)

### (Manufacturing and Evaluation of Electronic Device)

Fifteen parts by weight of phenolphthalein (from Tokyo Chemical Industry Co., Ltd.) as the flux-active compound, 15 parts by weight of PR-53467 (from Sumitomo Bakelite Co. , Ltd.) as the phenolic novolac resin, 45 parts by weight of EOCN-1020-70 (from Nippon Kayaku Co., Ltd.) as the epoxy resin, 15 parts by weight of YP-50 (from Tohto Kasei Co., Ltd.) as the phenoxy resin, 1.0 parts by weight of KBM-303 (from Shin-Etsu Chemical Co., Ltd.) as the silane coupling agent, 0.05 parts by weight of 2P4MZ (from Shikoku Chemical Corporation) as the imidazole compound, and 10 parts by weight of SO1050-LC (from Admatechs Co., Ltd.) as the inorganic filler were dissolved into acetone, to thereby prepare a varnish-like resin composition.
Next, the resin layer 3 was formed similarly as described in Example B1, an electronic device was further manufactured, and evaluated.

### (Example B5)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B1, except that the distance between the stack 4 and the radiant heat source 53 was adjusted to 100 mm. The duration from the start of heating of the stack 4 up to when the melting point of the solder (225°C) is reached was set to 7 minutes.

### (Example B6)

### (Formation of Filmy Resin Layer)

The resin layer 3 was formed similarly as described in Example B2.

### (Manufacturing and Evaluation of Electronic Device)

An electronic device was manufactured and evaluated similarly as described in Example B5.

### (Example B7)

### (Formation of Filmy Resin Layer)

The resin layer 3 was formed similarly as described in Example B3.

### (Manufacturing and Evaluation of Electronic Device)

An electronic device was manufactured and evaluated similarly as described in Example B5.

### (Example B8)

### (Formation of Filmy Resin Layer)

The resin layer 3 was formed similarly as described in Example B4.

### (Manufacturing and Evaluation of Electronic Device)

An electronic device was manufactured and evaluated similarly as described in Example B5.

### (Example B9)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B1, except that the distance between the stack 4 and the radiant heat source 53 was adjusted to 60 mm. The duration from the start of heating of the stack 4 up to when the melting point of the solder (225°C) is reached was set to 5 seconds.

### (Example B10)

### (Formation of Filmy Resin Layer)

The resin layer 3 was formed similarly as described in Example B2.

### (Manufacturing and Evaluation of Electronic Device)

An electronic device was manufactured and evaluated similarly as described in Example B9.

### (Example B11)

### (Formation of Filmy Resin Layer)

The resin layer 3 was formed similarly as described in Example B3.

### (Manufacturing and Evaluation of Electronic Device)

An electronic device was manufactured and evaluated similarly as described in Example B9.

### (Example B12)

### (Formation of Filmy Resin Layer)

The resin layer 3 was formed similarly as described in Example B4.

### (Manufacturing and Evaluation of Electronic Device)

An electronic device was manufactured and evaluated similarly as described in Example B9.

### (Example B13)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B1, except that nitrogen was used in place of air, as the fluid to be fed into the container 51.

### (Example B14)

### (Formation of Filmy Resin Layer)

The resin layer 3 was formed similarly as described in Example B2.

### (Manufacturing and Evaluation of Electronic Device)

An electronic device was manufactured and evaluated similarly as described in Example B13.

### (Example B15)

### (Formation of Filmy Resin Layer)

The resin layer 3 was formed similarly as described in Example B3.

### (Manufacturing and Evaluation of Electronic Device)

An electronic device was manufactured and evaluated similarly as described in Example B13.

### (Example B16)

### (Formation of Filmy Resin Layer)

The resin layer 3 was formed similarly as described in Example B4.

### (Manufacturing and Evaluation of Electronic Device)

An electronic device was manufactured and evaluated similarly as described in Example B13.

### (Example B17)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B5, except that nitrogen was used in place of air, as the fluid to be fed into the container 51.

### (Example B18)

### (Formation of Filmy Resin Layer)

The resin layer 3 was formed similarly as described in Example B2.

### (Manufacturing and Evaluation of Electronic Device)

An electronic device was manufactured and evaluated similarly as described in Example B17.

### (Example B19)

### (Formation of Filmy Resin Layer)

The resin layer 3 was formed similarly as described in Example B3.

### (Manufacturing and Evaluation of Electronic Device)

An electronic device was manufactured and evaluated similarly as described in Example B17.

### (Example B20)

### (Formation of Filmy Resin Layer)

The resin layer 3 was formed similarly as described in Example B4.

### (Manufacturing and Evaluation of Electronic Device)

An electronic device was manufactured and evaluated similarly as described in Example B17.

### (Example B21)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B9, except that nitrogen was used in place of air, as the fluid to be fed into the container 51.

### (Example B22)

### (Formation of Filmy Resin Layer)

The resin layer 3 was formed similarly as described in Example B2.

### (Manufacturing and Evaluation of Electronic Device)

An electronic device was manufactured and evaluated similarly as described in Example B21.

### (Example B23)

### (Formation of Filmy Resin Layer)

The resin layer 3 was formed similarly as described in Example B3.

### (Manufacturing and Evaluation of Electronic Device)

An electronic device was manufactured and evaluated similarly as described in Example B21.

### (Example B24)

### (Formation of Filmy Resin Layer)

The resin layer 3 was formed similarly as described in Example B4.

### (Manufacturing and Evaluation of Electronic Device)

An electronic device was manufactured and evaluated similarly as described in Example B21.

### (Example B25)

An electronic device was manufactured similarly as described in Example B17, except that the pressure to be applied to the stack 4 was adjusted to 0.3 MPa.

### (Example B26)

An electronic device was manufactured similarly as described in Example B17, except that the pressure to be applied to the stack 4 was adjusted to 0.8 MPa.

### (Example B27)

An electronic device was manufactured similarly as described in Example B21, except that the pressure to be applied to the stack 4 was adjusted to 0.3 MPa.

### (Example B28)

An electronic device was manufactured similarly as described in Example B21, except that the pressure to be applied to the stack 4 was adjusted to 0.8 MPa.

### (Comparative Example A1)

### (Formation of Filmy Resin Layer)

The resin layer 3 was formed similarly as described in Example A1.

### (Manufacturing and Evaluation of Electronic Device)

An electronic device was manufactured and evaluated similarly as described in Example A1, except that the duration from the start of heating of the stack 4 up to when the melting point of solder (225°C) is reached was set to 16 minutes.

### (Comparative Example A2)

### (Formation of Filmy Resin Layer)

The resin layer 3 was formed similarly as described in Example A2.

### (Manufacturing and Evaluation of Electronic Device)

An electronic device was manufactured and evaluated similarly as described in Comparative Example A1.

### (Comparative Example A3)

### (Formation of Filmy Resin Layer)

The resin layer 3 was formed similarly as described in Example A3.

### (Manufacturing and Evaluation of Electronic Device)

An electronic device was manufactured and evaluated similarly as described in Comparative Example A1.

### (Comparative Example A4)

### (Formation of Filmy Resin Layer)

The resin layer 3 was formed similarly as described in Example A4.

### (Manufacturing and Evaluation of Electronic Device)

An electronic device was manufactured and evaluated similarly as described in Comparative Example A1.

### (Comparative Example A5)

### (Formation of Filmy Resin Layer)

The resin layer 3 was formed similarly as described in Example A1.

### (Manufacturing and Evaluation of Electronic Device)

An electronic device was manufactured and evaluated similarly as described in Comparative Example A1, except that nitrogen was used in place of air, as the fluid to be fed into the container 51.

### (Comparative Example A6)

### (Formation of Filmy Resin Layer)

The resin layer 3 was formed similarly as described in Example A2.

### (Manufacturing and Evaluation of Electronic Device)

An electronic device was manufactured and evaluated similarly as described in Comparative Example A5.

### (Comparative Example A7)

### (Formation of Filmy Resin Layer)

The resin layer 3 was formed similarly as described in Example A3.

### (Manufacturing and Evaluation of Electronic Device)

An electronic device was manufactured and evaluated similarly as described in Comparative Example A5.

### (Comparative Example A8)

### (Formation of Filmy Resin Layer)

The resin layer 3 was formed similarly as described in Example A4.

### (Manufacturing and Evaluation of Electronic Device)

An electronic device was manufactured and evaluated similarly as described in Comparative Example A5.

### (Comparative Example B1)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B1, except that the distance between the stack 4 and the radiant heat source 53 was adjusted to 180 mm. The duration from the start of heating of the stack 4 up to when the melting point of the solder (225°C) is reached was set to 16 minutes.

### (Comparative Example B2)

### (Formation of Filmy Resin Layer)

The resin layer 3 was formed similarly as described in Example B2.

### (Manufacturing and Evaluation of Electronic Device)

An electronic device was manufactured and evaluated similarly as described in Comparative Example B1.

### (Comparative Example B3)

### (Formation of Filmy Resin Layer)

The resin layer 3 was formed similarly as described in Example B3.

### (Manufacturing and Evaluation of Electronic Device)

An electronic device was manufactured and evaluated similarly as described in Comparative Example B1.

### (Comparative Example B4)

### (Formation of Filmy Resin Layer)

The resin layer 3 was formed similarly as described in Example B4.

### (Manufacturing and Evaluation of Electronic Device)

An electronic device was manufactured and evaluated similarly as described in Comparative Example B1.

### (Comparative Example B5)

### (Formation of Filmy Resin Layer)

The resin layer 3 was formed similarly as described in Example B1.

### (Manufacturing and Evaluation of Electronic Device)

An electronic device was manufactured and evaluated similarly as described in Comparative Example B1, except that nitrogen was used in place of air, as the fluid to be fed into the container 51.

### (Comparative Example B6)

### (Formation of Filmy Resin Layer)

The resin layer 3 was formed similarly as described in Example B2.

### (Manufacturing and Evaluation of Electronic Device)

An electronic device was manufactured and evaluated similarly as described in Comparative Example B5.

### (Comparative Example B7)

### (Formation of Filmy Resin Layer)

The resin layer 3 was formed similarly as described in Example B3.

### (Manufacturing and Evaluation of Electronic Device)

An electronic device was manufactured and evaluated similarly as described in Comparative Example B5.

### (Comparative Example B8)

### (Formation of Filmy Resin Layer)

The resin layer 3 was formed similarly as described in Example B4.

### (Manufacturing and Evaluation of Electronic Device)

An electronic device was manufactured and evaluated similarly as described in Comparative Example B5.

### (Comparative Example B9)

### (Formation of Filmy Resin Layer)

The resin layer 3 was formed similarly as described in Example B1.

### (Manufacturing and Evaluation of Electronic Device)

An electronic device was manufactured and evaluated similarly as described in Example B5, except that the stack 4 was not pressurized.

### (Comparative Example B10)

### (Formation of Filmy Resin Layer)

The resin layer 3 was formed similarly as described in Example B2.

### (Manufacturing and Evaluation of Electronic Device)

An electronic device was manufactured and evaluated similarly as described in Comparative Example B9.

### (Comparative Example B11)

### (Formation of Filmy Resin Layer)

The resin layer 3 was formed similarly as described in Example B3.

### (Manufacturing and Evaluation of Electronic Device)

An electronic device was manufactured and evaluated similarly as described in Comparative Example B9.

### (Comparative Example B12)

### (Formation of Filmy Resin Layer)

The resin layer 3 was formed similarly as described in Example B4.

### (Manufacturing and Evaluation of Electronic Device)

An electronic device was manufactured and evaluated similarly as described in Comparative Example B9.

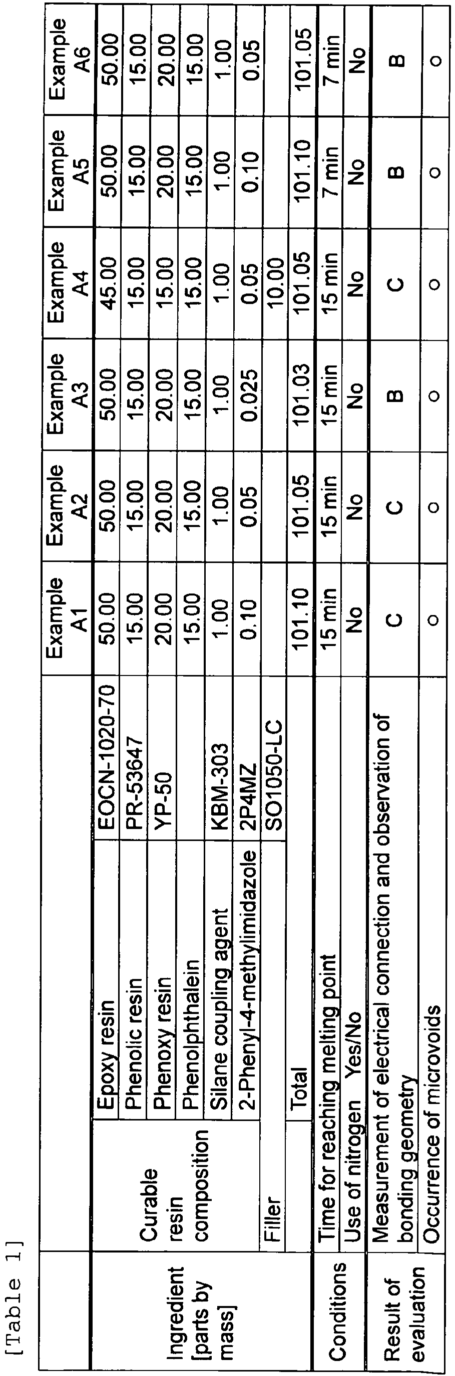

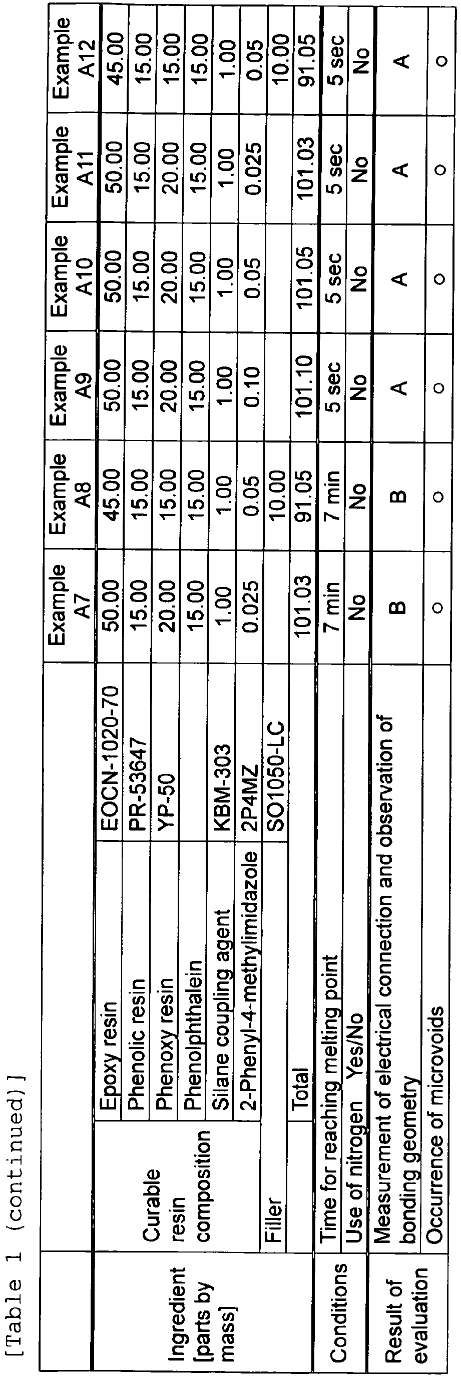

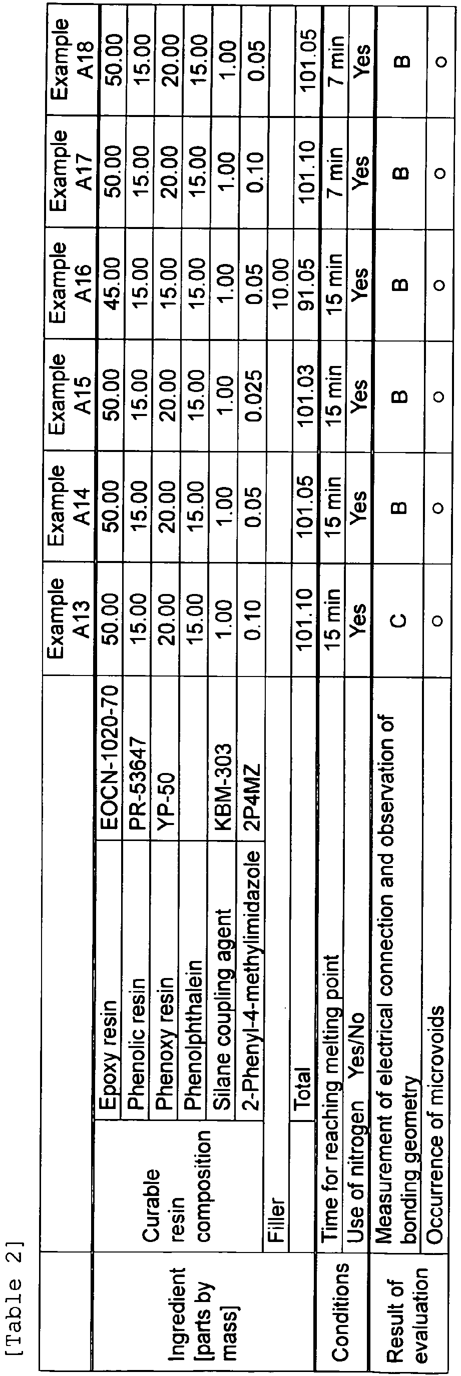

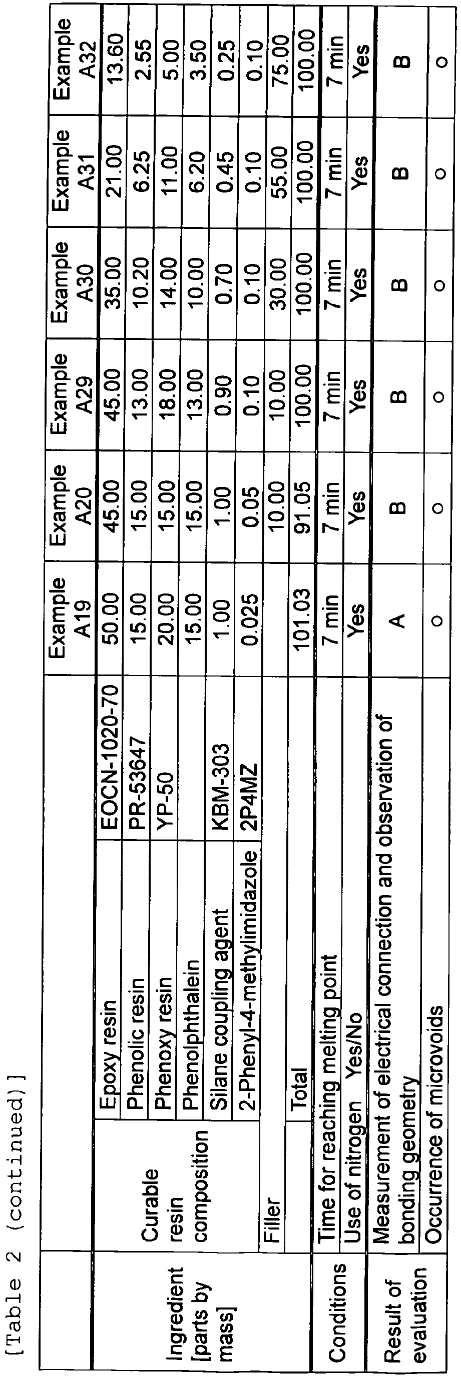

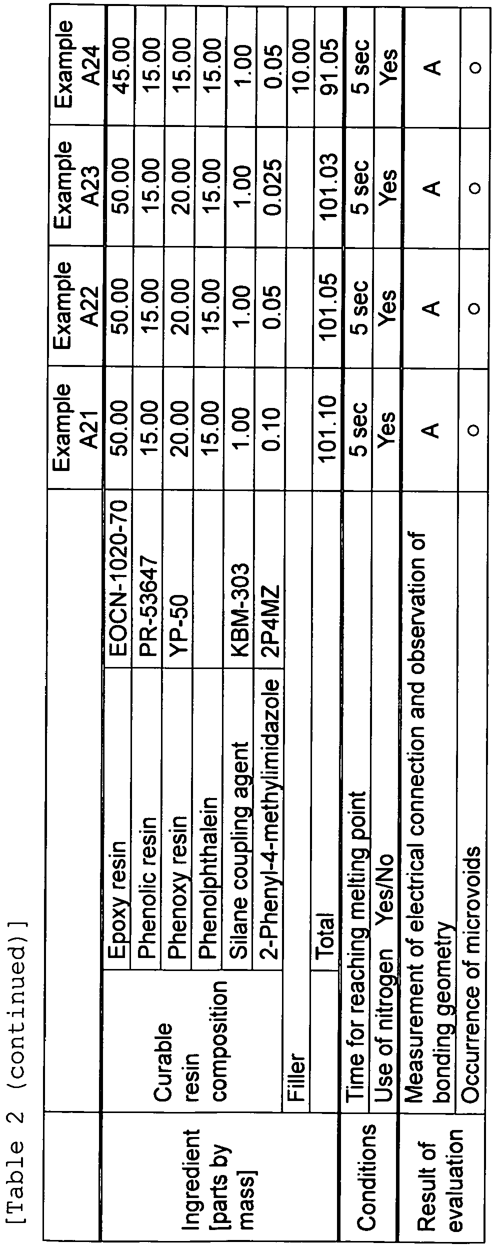

**[Table 3]**

| | | | | **Example A33** | **Example A34** | **Example A35** | **Example A36** | **Example A37** |
|---|---|---|---|---|---|---|---|---|
| Ingredient [parts by mass] | Curable resin composition | Epoxy resin | EPICLON 840-S | 50.00 | 45.00 | 35.00 | 21.00 | 13.60 |
| | | Phenolic resin | VR-9305 | 15.00 | 13.00 | 10.20 | 6.25 | 2.55 |
| | | Phenoxy resin | YX8100 | 20.00 | 18.00 | 14.00 | 11.00 | 5.00 |
| | | Phenolphthalein | | 15.00 | 13.00 | 10.00 | 6.20 | 3.50 |
| | | Silane coupling agent | KBM-303 | 1.00 | 0.90 | 0.70 | 0.45 | 0.25 |
| | | 2-Phenyl-4-methylimidazole | 2P4MZ | 0.10 | 0.10 | 0.10 | 0.10 | 0.10 |
| | Filler | | SO1050-LC | | 10.00 | 30.00 | 55.00 | 75.00 |
| | | Total | | 101.10 | 100.00 | 100.00 | 100.00 | 100.00 |
| Conditions | Time for reaching melting point | | | 7 min | 7 min | 7 min | 7 min | 7 min |
| | Use of nitrogen Yes/No | | | Yes | Yes | Yes | Yes | Yes |
| Result of evaluation | Measurement of electrical connection and observation of bonding geometry | | | B | B | B | B | B |
| | Occurrence of microvoids | | | O | O | O | O | O |

**[Table 4]**

| | | | | **Example A38** | **Example A39** | **Example A40** | **Example A41** | **Example A42** |
|---|---|---|---|---|---|---|---|---|
| Ingredient [parts by mass] | Curable resin composition | Epoxy resin | EXA-830LVP | 35.45 | 35.45 | 35.45 | 49.63 | 21.27 |
| | | Phenolic resin | PR-51470 | 5.33 | 5.33 | 5.33 | 7.46 | 3.20 |
| | | | MEH-8000 | 5.33 | 5.33 | 5.33 | 7.46 | 3.20 |
| | | Phenolphthalein | | 3.55 | 3.55 | 3.55 | 4.97 | 2.13 |
| | | 2-Phenyl-4-methylimidazole | 2P4MZ | 0.35 | 0.18 | 0.088 | 0.49 | 0.21 |
| | Filler | | SO1050-LC | 50.00 | 50.00 | 50.00 | 30.00 | 70.00 |
| | | Total | | 100.00 | 99.83 | 99.74 | 100.00 | 100.00 |
| Conditions | Time for reaching melting point | | | 7 min | 7 min | 7 min | 7 min | 7 min |
| | Use of nitrogen Yes/No | | | Yes | Yes | Yes | Yes | Yes |
| Result of evaluation | Measurement of electrical connection and observation of bonding geometry Occurrence of microvoids | | | B | B | B | B | B |
| | | | | O | O | O | O | O |

**[Table 5]**

| | | | | **Example A25** | **Example A17** | **Example A26** | **Example A27** | **Example A21** | **Example A28** |
|---|---|---|---|---|---|---|---|---|---|
| Ingredient [parts by mass] | Curable resin composition | Epoxy resin | EOCN-1020-70 | 50.00 | 50.00 | 50.00 | 50.00 | 50.00 | 50.00 |
| | | Phenolic resin | PR-53647 | 15.00 | 15.00 | 15.00 | 15.00 | 15.00 | 15.00 |
| | | Phenoxy resin | YP-50 | 20.00 | 20.00 | 20.00 | 20.00 | 20.00 | 20.00 |
| | | Phenolphthalein | | 15.00 | 15.00 | 15.00 | 15.00 | 15.00 | 15.00 |
| | | Silane coupling agent | KBM-303 | 1.00 | 1.00 | 1.00 | 1.00 | 1.00 | 1.00 |
| | | 2-Phenyl-4-methylimidazole | 2P4MZ | 0.10 | 0.10 | 0.10 | 0.10 | 0.10 | 0.10 |
| | Filler | | | | | | | | |
| | | Total | | 101.10 | 101.10 | 101.10 | 101.10 | 101.10 | 101.10 |
| Conditions | Time for reaching melting point | | | 7 min | 7 min | 7 min | 5 sec | 5 sec | 5 sec |
| | Pressurized atmosphere | | | 0.3MPa | 0.5MPa | 0.8MPa | 0.3MPa | 0.5MPa | 0.8MPa |
| | Use of nitrogen Yes/No | | | Yes | Yes | Yes | Yes | Yes | Yes |
| Result of evaluation | Measurement of electrical connection and observation of bonding geometry | | | B | B | B | A | A | A |
| | Occurrence of microvoids | | | O | O | O | O | O | O |

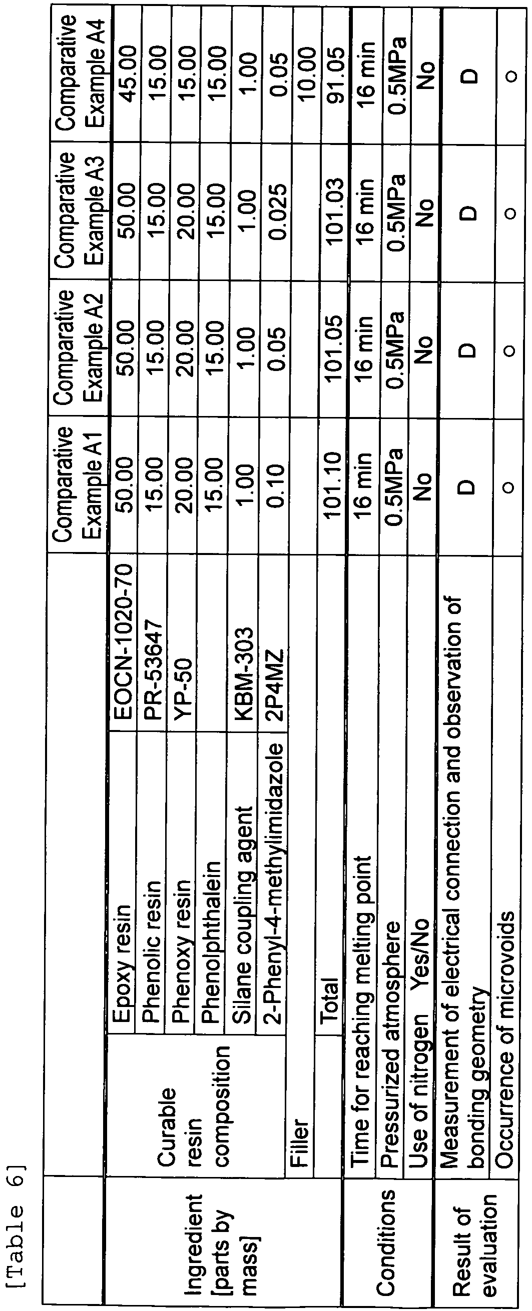

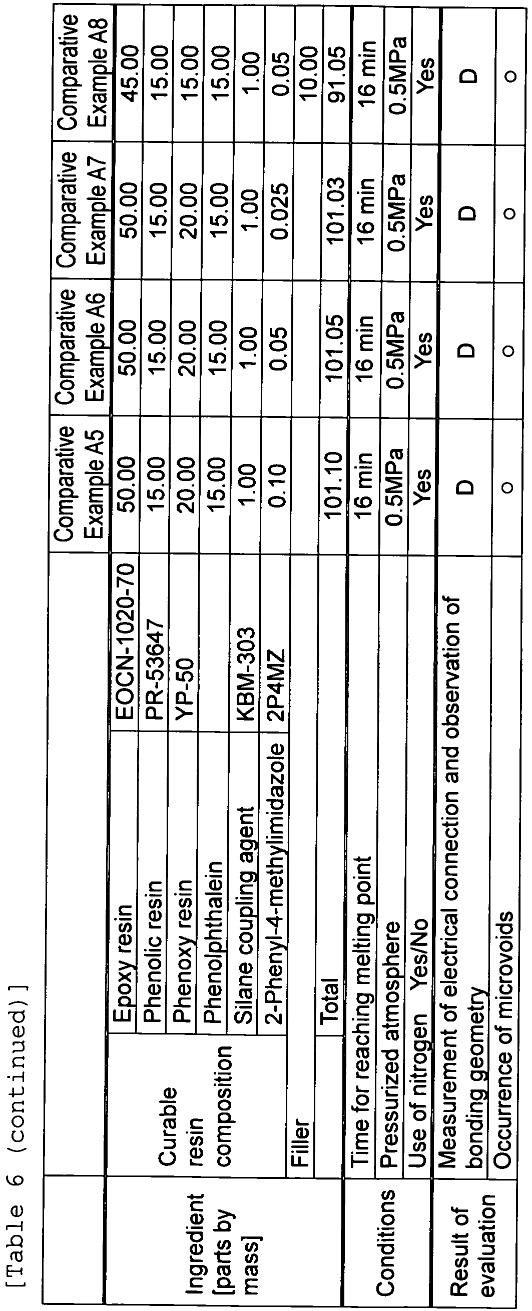

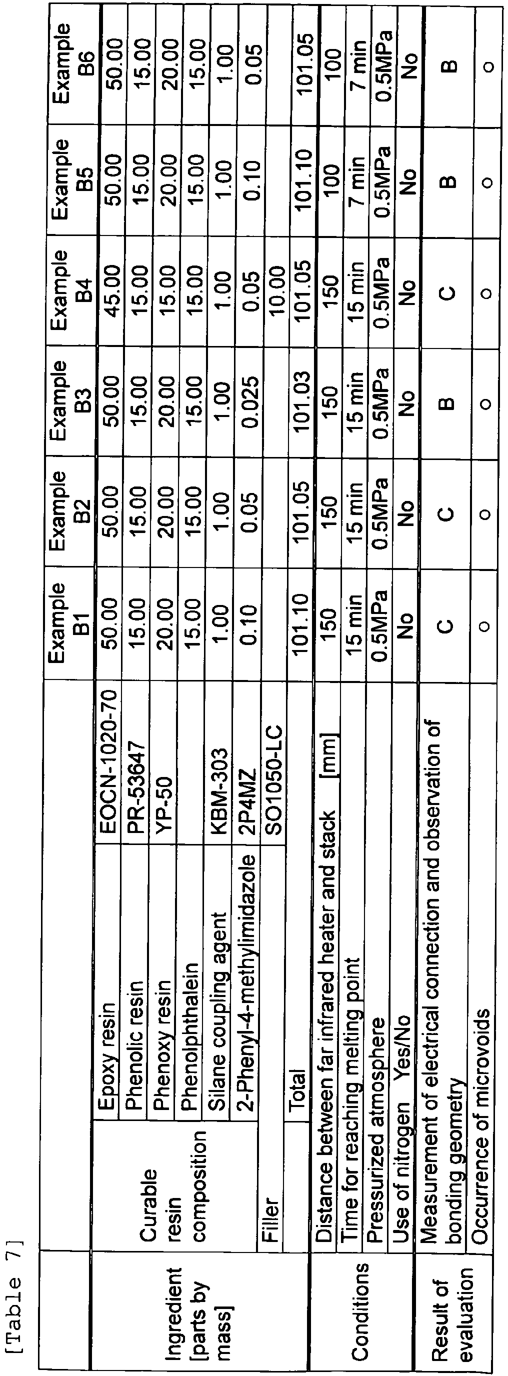

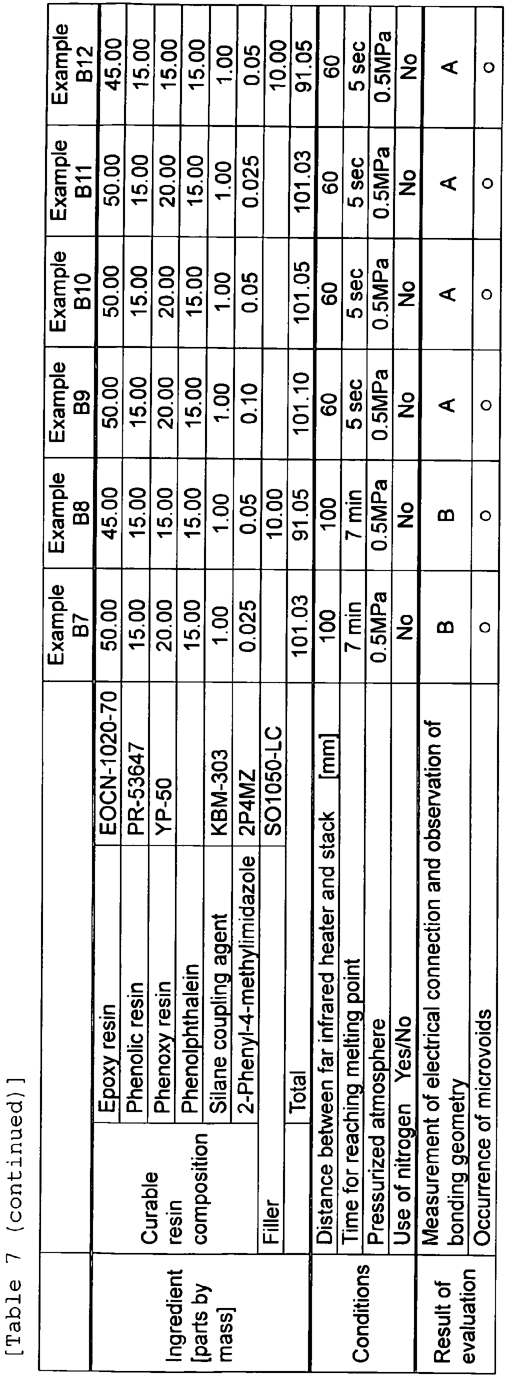

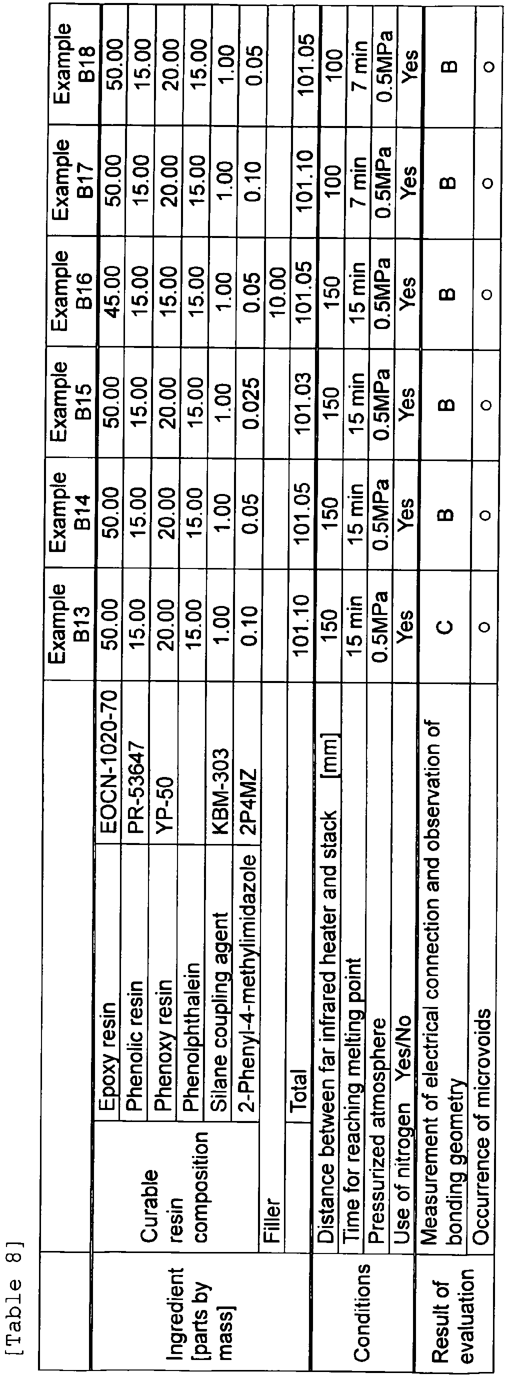

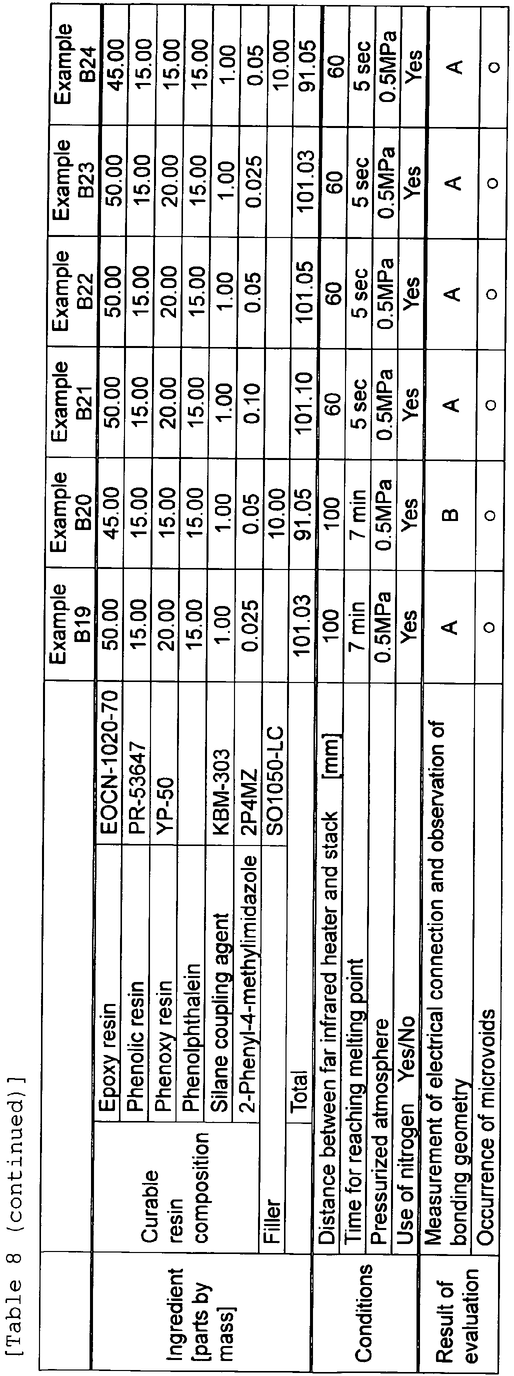

**[Table 9]**

| | | | | **Example B25** | **Example B17** | **Example B26** | **Example B27** | **Example B21** | **Example B28** |
|---|---|---|---|---|---|---|---|---|---|
| Ingredient [parts by mass] Conditions | Curable resin composition | Epoxy resin | EOCN-1020-70 | 50.00 | 50.00 | 50.00 | 50.00 | 50.00 | 50.00 |
| | | Phenolic resin | PR-53647 | 15.00 | 15.00 | 15.00 | 15.00 | 15.00 | 15.00 |
| | | Phenoxy resin | YP-50 | 20.00 | 20.00 | 20.00 | 20.00 | 20.00 | 20.00 |
| | | Phenolphthalein | | 15.00 | 15.00 | 15.00 | 15.00 | 15.00 | 15.00 |
| | | Silane coupling agent | KBM-303 | 1.00 | 1.00 | 1.00 | 1.00 | 1.00 | 1.00 |
| | | 2-Phenyl-4-methylimidazole | 2P4MZ | 0.10 | 0.10 | 0.10 | 0.10 | 0.10 | 0.10 |
| | Filler | | SO1050-LC | | | | | | |
| | | Total | | 101.10 | 101.10 | 101.10 | 101.10 | 101.10 | 101.10 |
| | Distance between far infrared heater and stack [mm] | | | 100 | 100 | 100 | 60 | 60 | 60 |
| | Time for reaching melting point | | | 7 min | 7 min | 7 min | 5 sec | 5 sec | 5 sec |
| | Pressurized atmosphere | | | 0.3MPa | 0.5MPa | 0.8MPa | 0.3MPa | 0.5MPa | 0.8MPa |
| | Use of nitrogen Yes/No | | | Yes | Yes | Yes | Yes | Yes | Yes |
| Result of evaluation | Measurement of electrical connection and observation of bonding geometry | | | B | B | B | A | A | A |
| | Occurrence of microvoids | | | O | O | O | O | O | O |

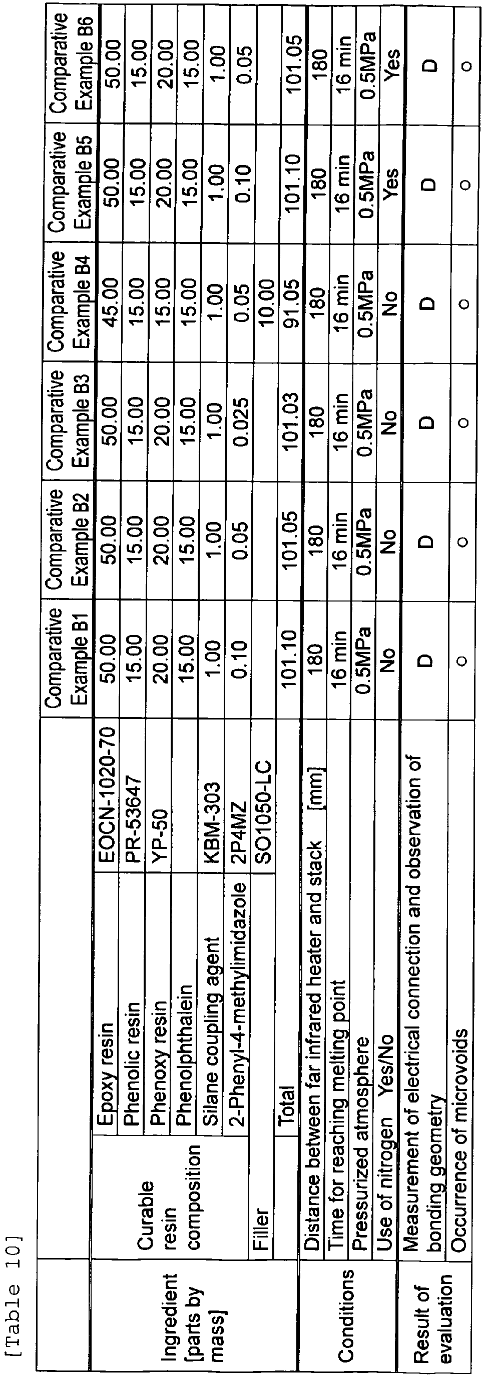

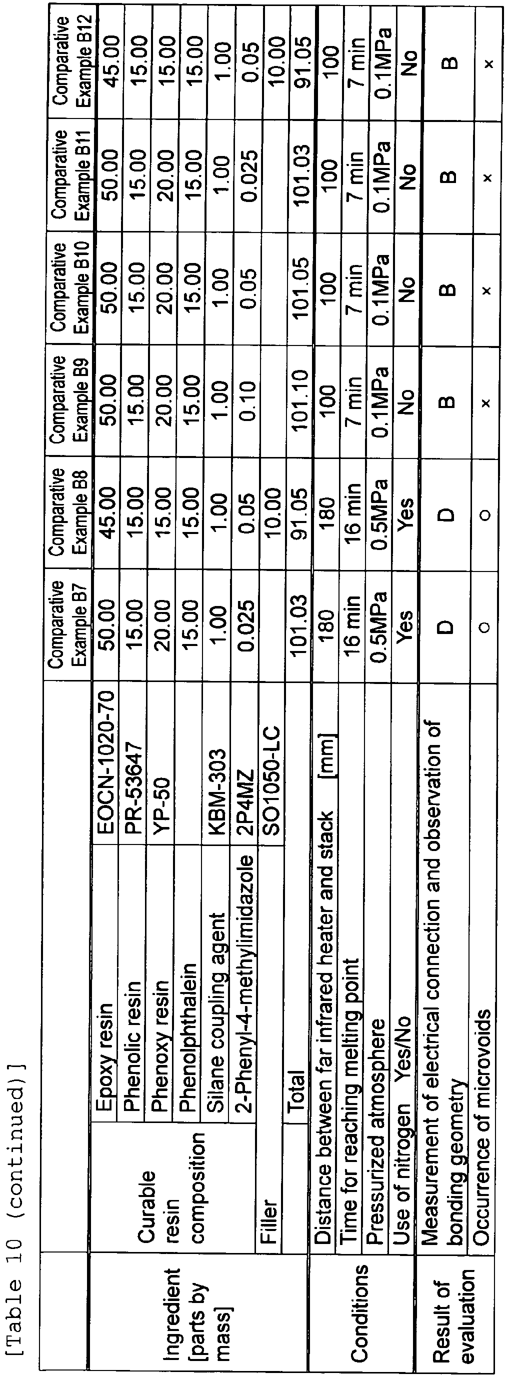

Results of Examples A1 to A42, B1 to B28, Comparative Examples A1 to A8, and Comparative Examples B1 to B12 are shown in Tables 1 to 10.
All of Examples A1 to A42, and B1 to B28 showed no electrical connection failure, and no microvoids produced in the resin layer. In contrast, all of Comparative Examples A1 to A8, and B1 to B8 showed electrical connection failure. All of Comparative Example B9 to B12 showed the microvoids produced in the resin layer, but showed no electrical connection failure.
It was confirmed that when nitrogen, which is a non-oxidative gas, was used as the pressurizing fluid typically shown in Examples A13 to A42, and B13 to B28, wetting of solder was improved as compared with the case of using air, and less numbers of notches were observed even if they should be found on the section of solder bonding.
Even if the resin layer was configured based on the composition and materials different from those in Examples A1 to A42 and B1 to B28, effects similar to those in these Examples were obtained by adjusting the duration from the point of time immediately after the start of heating of the stack, up to the point of time when the temperature of the stack reaches the melting point of the solder layer, to 5 seconds or longer, and 15 minutes or shorter.

Next, Examples according to the second aspect of the invention will be explained.

### (Example C1)

An electronic device was manufactured by a method similar to that of the third embodiment.

### (Formation of Resin Layer 3)

Fifteen parts by weight of phenolphthalein (from Tokyo Chemical Industry Co., Ltd.) as the flux-active compound, 15 parts by weight of PR-53647 (from Sumitomo Bakelite Co., Ltd.) as the phenolic novolac resin, 50 parts by weight of EOCN-1020-70 (from Nippon Kayaku Co., Ltd.) as the epoxy resin, 20 parts by weight of YP-50 (from Tohto Kasei Co., Ltd.) as the phenoxy resin, 1.0 parts by weight of KBM-303 (from Shin-Etsu Chemical Co., Ltd.) as the silane coupling agent, and 0.05 parts by weight of 2P4MZ (from Shikoku Chemical Corporation) as the imidazole compound were dissolved into acetone, to thereby prepare a varnish-like resin composition.
The varnish-like resin composition obtained in the above was coated using a comma coater over a polyester sheet (base), dried at 100°C, at which acetone vaporizes, for 3 minutes, to thereby obtain a filmy resin layer of 25 µm thick formed on the base. The film herein is configured as if a plurality of resin layers 3 are combined to give a single sheet, similarly to that in the third embodiment.

### (Manufacturing of Electronic Device)

The film formed on the base (configured as if a plurality of resin layers 3 are combined to give a single sheet) was laminated over the surface of a circuit substrate (first electronic component 1), wherein the surface having solder bumps (solder layer 112) formed thereon, using a vacuum laminator at 100°C under a pressure of 0.7 MPa. The base was then separated.
A plurality of first electronic components 1 arranged herein configure a single large circuit substrate, similarly to that in the third embodiment.
Next, a plurality of semiconductor chips (second electronic components 2) were prepared.
The member 53 adopted herein was a glass plate (weighing 450 g) having the lattice-patterned trenches 531 formed thereon.
First, the first terminals 11 of the circuit substrate and the second terminals 21 of the semiconductor chips (second electronic components 2) were opposedly aligned, to thereby form the stacks 4. A portion of the film, configured so as to combine a plurality of resin layers 3, exposes between the adjacent semiconductor chips, similarly to the case of the third embodiment.
Next, the container 51 of the apparatus 5 was preheated at 100°C, the stacks 4 were placed on the stage 54 of the container 51, and the glass plate was placed on the stacks 4, while aligning it so that the end faces of the electronic components 2 project out from the side faces 531A of the trenches 531 inwards the trenches 531. The trenches 531 of the member 53 and the gaps between the adjacent second electronic components 2 were opposed, and also the trenches 531 and a portion of the film were opposed.
The container 51 was then fed with a fluid (air), pressurized at 0.5 MPa, and the stacks 4 were heated up to the melting point of the solder layer 112 (225°C), the temperature was then lowered to 180°C, and the stacks 4 were heated under pressure for 60 minutes. The duration from the start of heating of the stacks 4 (the point of time when the opening of the container 51, through which the stacks 4 were brought, was closed after the placement of the stacks 4), up to the point of time when the temperature of the stack 4 reached the melting point of solder (225°C), was set to 5 seconds.
In the process of solder bonding of the first terminals 11 and the second terminals 21 (when the second terminals 21 intruded into the solder layers 112 on the first terminals 11 under the load applied through the member 53 onto the stacks 4, and the distance between the first terminals 11 and the second terminals 21 was stabilized at a constant value), the load applied to the first terminals 11 and the second terminals 21 was found to be 0.001 MPa.

### (Example C2)

### (Manufacturing of Electronic Device)

In the process of solder bonding of the first terminals 11 and the second terminals 21, the load applied to the first terminals 11 and the second terminals 21 was adjusted to 0.01 MPa. The duration from the start of heating of the stacks 4 (the point of time when the opening of the container 51, through which the stacks 4 were brought, was closed after the placement of the stacks 4), up to the point of time when the temperature of the stack 4 reached the melting point of solder (225°C), was set to 15 minutes. Except for these aspects, an electronic component was manufactured similarly as described in Example C1.
The number of semiconductor chips herein was reduced as compared with that in Example C1, in order to adjust the load to be applied to the terminals. However, similarly as described in Example C1, the plurality of stacks 4 were concomitantly bonded with solder, and the resin layer 3 was cured.

### (Example C3)

### (Manufacturing of Electronic Device)

An electronic device was manufactured similarly as described in Example C1, except that the load applied to the first terminals 11 and the second terminals 21, in the process of solder bonding of the first terminals 11 and the second terminals 21, was adjusted to 40 MPa.
The number of semiconductor chips herein was reduced as compared with that in Example C1, in order to adjust the load to be applied to the terminals. However, similarly as described in Example C1, the plurality of stacks 4 were concomitantly bonded with solder, and the resin layer 3 was cured.

### (Example C4)

### (Manufacturing of Electronic Device)

An electronic device was manufactured similarly as described in Example C1, except that the load applied to the first terminals 11 and the second terminals 21, in the process of solder bonding of the first terminals 11 and the second terminals 21, was adjusted to 50 MPa.
The number of semiconductor chips herein was reduced as compared with that in Example C1, in order to adjust the load to be applied to the terminals. However, similarly as described in Example C1, the plurality of stacks 4 were concomitantly bonded with solder, and the resin layer 3 was cured.

### (Example C5)

### (Manufacturing of Electronic Device)

An electronic device was manufactured similarly as described in Example C1, except that nitrogen was used in place of air, as the fluid to be fed into the container 51.

### (Example C6)

### (Manufacturing of Electronic Device)

An electronic device was manufactured similarly as described in Example C2, except that nitrogen was used in place of air, as the fluid to be fed into the container 51.

### (Example C7)

### (Manufacturing of Electronic Device)

An electronic device was manufactured similarly as described in Example C3, except that nitrogen was used in place of air, as the fluid to be fed into the container 51.

### (Example C8)

### (Manufacturing of Electronic Device)

An electronic device was manufactured similarly as described in Example C4, except that nitrogen was used in place of air, as the fluid to be fed into the container 51.

### (Example C9)

An electronic device was manufactured according to a method of the fourth embodiment. The electronic device herein was manufactured using the apparatus illsutrated in FIG. 14. Except for these aspects, the process is similar to that in Example C1.
More specifically, the film formed on the base (configured as if a plurality of resin layers 3 are combined to give a single sheet, manufactured in the first embodiment) was laminated over the surface of a circuit substrate (first electronic component 1), wherein the surface having solder bumps (solder layer 112) formed thereon, using a vacuum laminator at 100°C under a pressure of 0.7 MPa. The base was then separated.
A plurality of first electronic components 1 arranged herein configure a single large circuit substrate, similarly to that in the fourth embodiment.
Next, a plurality of semiconductor chips (second electronic components 2) were prepared.
The member 53 adopted herein was a metal plate (weighing 450 g) having the lattice-patterned trenches 531 formed thereon.
First, the first terminals 11 of the circuit substrate and the second terminals 21 of the semiconductor chips (second electronic components 2) were opposedly aligned, to thereby form the stacks 4. A portion of the film, configured so as to combine a plurality of resin layers 3, exposes between the adjacent semiconductor chips, similarly to the case of the fourth embodiment.
Next, the upper die 511 in the container 51 of the apparatus 6 was preheated at 260°C, the lower die 512 was preheated at 50°C, and the plurality of stacks 4 were placed on the stage 611 in the container 51.
Next, the stage 611 was moved using the energizing unit 612 towards the upper die 511, and the member 53 was brought into contact with the stacks 4 so that the end faces of the electronic components 2 project out from the side faces 531A of the trenches 531 inwards the trenches 531. The trenches 531 of the member 53 and the gaps between the adjacent second electronic components 2 were opposed, and also the trenches 531 and a portion of the film were opposed.
The container 51 was then fed with a fluid (air), pressurized at 0.5 MPa, and the stacks 4 were heated up to the melting point of the solder layer 112 (225°C), the temperature was then lowered to 180°C, and the stacks 4 were heated under pressure for 60 minutes. The duration from the start of heating of the stacks 4 (the point of time when the opening of the container 51, through which the stacks 4 were brought, was closed after the placement of the stacks 4), up to the point of time when the temperature of the stack 4 reached the melting point of solder (225°C), was set to 5 seconds.
In the process of solder bonding of the first terminals 11 and the second terminals 21 (when the second terminals 21 intruded into the solder layers 112 on the first terminals 11 under the load applied through the member 53 onto the stacks 4, and the distance between the first terminals 11 and the second terminals 21 was stabilized at a constant value), the load applied to the first terminals 11 and the second terminals 21 was found to be 0.1 MPa.

### (Comparative Example C1)

### (Manufacturing of Electronic Device)

An electronic device was manufactured similarly as described in Example C1, except that a member having no trenches 531 formed thereon (a glass plate having a flat surface on the side opposed to the stacks 4) was used as the member in Example C1. Other aspects are same as those in Example C1.

### (Comparative Example C2)

### (Manufacturing of Electronic Device)

An electronic device was manufactured similarly as described in Example C2, except that a member having no trenches 531 formed thereon (a glass plate having a flat surface on the side opposed to the stacks 4) was used as the member in Example C1. Other aspects are same as those in Example C2.

### (Comparative Example C3)

### (Manufacturing of Electronic Device)

An electronic device was manufactured similarly as described in Example C3, except that a member having no trenches 531 formed thereon (a glass plate having a flat surface on the side opposed to the stacks 4) was used as the member in Example C1. Other aspects are same as those in Example C3.

### (Comparative Example C4)

### (Manufacturing of Electronic Device)

An electronic device was manufactured similarly as described in Example C4, except that a member having no trenches 531 formed thereon (a glass plate having a flat surface on the side opposed to the stacks 4) was used as the member in Example C1. Other aspects are same as those in Example C4.

### (Evaluation of Electronic Device)

The electronic devices obtained in the individual Examples and Comparative Examples were evaluated as follows.

### 1. Measurement of Electrical Connection and Observation of Resin Exclusiveness

On each of the thus-obtained electronic devices, a pair of adjacent solder-connected portions were arbitrarily selected, and connection resistance therebetween was measured using a digital multimeter. Pairs of adjacent solder-connected points were then arbitrarily selected at nine additional sites, and the contact resistance was similarly measured. The electrical connection was therefore measured at 10 sites in total. Next, the thus-obtained electronic device was cut, the section of the cured product was polished, and the solder-connected portions, for which the electrical connection has been measured, were observed under a SEM.
A: electrical connection confirmed at every of 10 sites, and the resin excluded from the solder-bonded portions;
B: electrical connection confirmed at every of 10 sites, but the resin incompletely excluded at 1 to 9 sites, showing intrusive residence of resin in the solder-bonded portions;
C: electrical connection confirmed at every of 10 sites, but showing intrusive residence of resin at every of 10 sites; and D: electrical connection failure confirmed even at a single site.
The samples given with the marks A, B and C are of no practical problem, whereas the samples given with the mark D are not suitable for practical use.

### 2. Occurrence of Microvoids in Resin Layer

The obtained electronic device was cut, and the section of the resin layer was polished. Next, all portions surrounded by the first electronic component, the second electronic component and two adjacent solder-connected portions were observed under a metallurgical microscope, in order to find occurrence of microvoids. Marks represent as follows:
o: no microvoids observed at every of 10 sites; and
×: microvoids observed even at a single site.
The microvoids observed herein had sizes which were of no proctical problem.

### 3. Adhesion of Resin on Top Surfaces of Semiconductor Chips

Five electronic devices obtained in each of Examples and Comparative Examples were observed so as to confirm adhesion of the resin on the top surfaces of the semiconductor chips.
o: No resin adhesion; and
×: resin adhesion observed.

Results of evaluation and conditions of manufacturing of the electronic devices are shown in Tables 11 to 13.

**[Table 11]**

| | | | | Example C1 | Example C2 | Example C3 | Example C4 |
|---|---|---|---|---|---|---|---|
| Ingredient [parts by mass] | Curable resin composition | Epoxy resin | EOCN-1020-70 | 50.00 | 50.00 | 50.00 | 50.00 |
| | | Phenolic resin | PR-53647 | 15.00 | 15.00 | 15.00 | 15.00 |
| | | Phenoxy resin | YP-50 | 20.00 | 20.00 | 20.00 | 20.00 |
| | | Phenolphthalein | | 15.00 | 15.00 | 15.00 | 15.00 |
| | | Silane coupling agent | KBM-303 | 1.00 | 1.00 | 1.00 | 1.00 |
| | | 2-Phenyl-4-methylimidazole | 2P4MZ | 0.05 | 0.05 | 0.05 | 0.05 |
| | Filter | | SO1050-LC | | | | |
| | | Total | | 101.05 | 101.05 | 101.05 | 101.05 |
| Conditions | Formation of trenches on member Yes/No | | | Yes | Yes | Yes | Yes |
| | Pressurization through fluid (MPa) | | | 0.5 | 0.5 | 0.5 | 0.5 |
| | Time for reaching melting point | | | 5 sec | 15 min | 5 sec | 5 sec |
| | Load applied to first and second terminals | | | 0.001MPa | 0.01MPa | 40MPa | 50MPa |
| | Use of nitrogen Yes/No | | | No | No | No | No |
| Result of evaluation | Measurement of electrical connection and residence of resin | | | C | B | B | C |
| | Occurrence of microvoids | | | o | o | o | o |
| | Adhesion of resin | | | o | o | o | o |

**[Table 12]**

| | | | | Example C5 | Example C6 | Example C7 | Example C8 | Example C9 |
|---|---|---|---|---|---|---|---|---|
| Ingredient [parts by mass] | Curable resin composition | Epoxy resin | EOCN-1020-70 | 50.00 | 50.00 | 50.00 | 50.00 | 50.00 |
| | | Phenolic resin | PR-53647 | 15.00 | 15.00 | 15.00 | 15.00 | 15.00 |
| | | Phenoxy resin | YP-50 | 20.00 | 20.00 | 20.00 | 20.00 | 20.00 |
| | | Phenolphthalein | | 15.00 | 15.00 | 15.00 | 15.00 | 15.00 |
| | | Silane coupling agent 2-Phenyl-4-methylimidazole | KBM-303 | 1.00 | 1.00 | 1.00 | 1.00 | 1.00 |
| | | | 2P4MZ | 0.05 | 0.05 | 0.05 | 0.05 | 0.05 |
| | Filler | | SO1050-LC | | | | | |
| | | Total | | 101.05 | 101.05 | 101.05 | 101.05 | 101.05 |
| Conditions | Formation of trenches on member Yes/No | | | Yes | Yes | Yes | Yes | Yes |
| | Pressurization through fluid (MPa) | | | 0.5 | 0.5 | 0.5 | 0.5 | 0.5 |
| | Time for reaching melting point | | | 5 sec | 15 min | 5 sec | 5 sec | 5 sec |
| | Load applied to first and second terminals | | | 0.001MPa | 0.01MPa | 40MPa | 50MPa | 0.1MPa |
| | Use of nitrogen Yes/No | | | Yes | Yes | Yes | Yes | No |
| Result of evaluation | Measurement of electrical connection and residence of resin | | | B | B | A | B | B |
| | Occurrence of microvoids | | | o | o | o | o | o |
| | Adhesion of resin | | | o | o | o | o | o |

**[Table 13]**

| | | | | Comparative Example C1 | Comparative Example C2 | Comparative Example C3 | Comparative Example C4 |
|---|---|---|---|---|---|---|---|
| Ingredient [parts by mass] | Curable resin composition | Epoxy resin | EOCN-1020-70 | 50.00 | 50.00 | 50.00 | 50.00 |
| | | Phenolic resin | PR-53647 | 15.00 | 15.00 | 15.00 | 15.00 |
| | | Phenoxy resin | YP-50 | 20.00 | 20.00 | 20.00 | 20.00 |
| | | Phenolphthalein | | 15.00 | 15.00 | 15.00 | 15.00 |
| | | Silane coupling agent | KBM-303 | 1.00 | 1.00 | 1.00 | 1.00 |
| | | 2-Phenyl-4-methylimidazole | 2P4MZ | 0.05 | 0.05 | 0.05 | 0.05 |
| | Filler | | SO1050-LC | | | | |
| | | Total | | 101.05 | 101.05 | 101.05 | 101.05 |
| Conditions | Formation of trenches on member Yes/No | | | No | No | No | No |
| | Pressurization through fluid (MPa) | | | 0.5 | 0.5 | 0.5 | 0.5 |
| | Time for reaching melting point | | | 5 sec | 15 min | 5 sec | 5 sec |
| | Load applied to first and second terminals | | | 0.001MPa | 0.01MPa | 40MPa | 50MPa |
| | Use of nitrogen Yes/No | | | No | No | No | No |
| Result of evaluation | Measurement of electrical connection and residence of resin | | | C | C | C | C |
| | Occurrence of microvoids | | | × | × | × | × |
| | Adhesion of resin | | | × | × | × | × |

All of Examples C1 to C9 showed no electrical connection failure, and no microvoids.
Examples C1 to C9 showed no resin adhesion on the top surfaces of the semiconductor chips.
In contrast, Comparative Examples C1 to C4 showed intrusive residence of resin, and microvoids. Also adhesion of resin on the top surfaces of the semiconductor chips was observed.

This application claims priority right based on Japanese Patent Application No. 2009-240409 filed on October 19, 2009; Japanese Patent Application No. 2010-055329 filed on March 12, 2010; and Japanese Patent Application No. 2010-080453 filed on March 31, 2010, the entire contents of which are incorporated hereinto by reference.

## Claims

1. A method of manufacturing an electronic device which has a first electronic component and a second electronic component, the first electronic component having a first terminal having formed on the surface thereof a solder layer, and the second electronic component having a second terminal to be bonded to the first terminal of the first electronic component, the method comprising:
obtaining a stack of the first electronic component and the second electronic component, while placing between the first terminal and the second terminal a resin layer which contains a flux-active compound and a thermosetting resin;
bonding the first terminal and the second terminal with solder, by heating the stack at a temperature not lower than the melting point of the solder layer on the first terminal, while pressurizing the stack using a fluid; and
curing the resin layer,
wherein in the process of bonding the first terminal and the second terminal with solder,
the duration from the point of time immediately after the start of heating of the stack, up to the point of time when the temperature of the stack reaches the melting point of the solder layer, is set to 5 seconds or longer, and 15 minutes or shorter.

2. The method of manufacturing an electronic device according to Claim 1,
wherein in the process of bonding the first terminal and the second terminal with solder,
the stack is pressurized and heated, by placing the stack in a container and by heating the container, while introducing the fluid into the container.

3. The method of manufacturing an electronic device according to Claim 1 or 2,
wherein in the process of bonding the first terminal and the second terminal with solder,
the stack is pressurized through the fluid at 0. 1 MPa or higher and 10 MPa or lower.

4. The method of manufacturing an electronic device according to any one of Claims 1 to 3,
wherein in the process of bonding the first terminal and the second terminal with solder,
a non-oxidative gas is used as the fluid.

5. The method of manufacturing an electronic device according to any one of Claims 1 to 4,
wherein the resin layer, which contains the flux-active compound and the thermosetting resin, contains an inorganic filler.

6. An electronic device manufactured by the method described in any one of Claims 1 to 5.

7. The method of manufacturing an electronic device according to any one of Claims 1 to 5,
wherein in the process of bonding the first terminal and the second terminal with solder,
the stack is heated by radiant heat.

8. The method of manufacturing an electronic device according to Claim 7,
wherein the radiant heat is ascribable to far infrared radiation.

9. A method of manufacturing an electronic device which has a first electronic component and a second electronic component, the first electronic component having a first terminal having formed on the surface thereof a solder layer, and the second electronic component having a second terminal to be bonded to the first terminal of the first electronic component, the method comprising:
obtaining a stack of the first electronic component and the second electronic component, while placing between the first terminal and the second terminal a resin layer which contains a flux-active compound and a thermosetting resin;
bonding the first terminal and the second terminal with solder, by heating the stack at a temperature not lower than the melting point of the solder layer on the first terminal; and
curing the resin layer while pressurizing the stack using a fluid,
the process of bonding the first terminal and the second terminal with solder further comprising:
preparing a plurality of the stacks and a member having trenches formed thereon;
bringing the individual areas of the member, partitioned by the trenches, into contact with the first electronic components or the second electronic components of the individual stacks;
concomitantly opposing the trenches of the member, to gaps formed between the adjacent stacks and formed between the adjacent components brought into contact with the individual areas partitioned by the trenches; and
bonding the first terminals and the second terminals with solder, by heating the individual stacks at a temperature not lower than the melting point of the solder layers on the first terminals, while pressurizing the individual stacks in the direction of stacking thereof.

10. The method of manufacturing an electronic device according to Claim 9,
wherein, when the member having the trenches formed thereon is brought into contact with the stacks,
the end faces of the first electronic components or the second electronic components, brought into contact with the areas partitioned by the trenches, project out from the side faces of the trenches inwards the trenches.

11. The method of manufacturing an electronic device according to Claim 9 or 10,
wherein, when the member having the trenches formed thereon is brought into contact with the stacks,
either set of the first electronic components and the second electronic components of the individual stacks is brought into contact with the areas partitioned by the trenches,
the individual resin layers of the plurality of stacks are combined to give a single resin sheet,
a portion of the resin sheet exposes between either set of components of the adjacent stacks, when viewed from the direction of stacking of the stacks, and
when the member having the trenches formed thereon is brought into contact with the stacks, the exposed portion of the resin sheet is opposed to the trenches.

12. The method of manufacturing an electronic device according to any one of Claims 9 to 11,
wherein in the process of bonding the first terminals and the second terminals with solder,
the stacks are pressurized through the fluid.

13. The method of manufacturing an electronic device according to any one of Claims 9 to 12,
wherein in the process of bonding the first terminals and the second terminals with solder,
the member having the trenches formed thereon is placed on the stacks, and load is applied therethrough to the stacks.

14. The method of manufacturing an electronic device according to Claim 13,
wherein the member having the trenches formed thereon is composed of a material having a thermal conductivity of 40 W/m·K or smaller.

15. The method of manufacturing an electronic device according to Claim 14,
wherein the member is a glass plate or a stainless steel plate.

16. The method of manufacturing an electronic device according to any one of Claims 9 to 12,
wherein in the process of bonding the first terminals and the second terminals with solder,
the member having the trenches formed thereon is arranged so as to oppose with the stacks in the direction of stacking of the stacks, and
the stacks are applied with load by pressing the stacks against the member in the direction of stacking of the stacks.

17. The method of manufacturing an electronic device according to Claim 16,
wherein the member is kept under heating, and
the stacks are heated by being pressed against the member.

18. The method of manufacturing an electronic device according to any one of Claims 9 to 17,
wherein in the process of bonding the first terminals and the second terminals with solder,
the first terminals and the second terminals are applied with a load of 0.01 to 40 MPa.

19. The method of manufacturing an electronic device according to any one of Claims 9 to 18,
wherein the fluid is a non-oxidative gas.

20. The method of manufacturing an electronic device according to any one of Claims 9 to 19,
wherein in the process of bonding the first terminals and the second terminals with solder,
the duration between the point of time immediately after the start of heating of the stacks, up to the point of time when the temperature of the stacks reaches the melting point of the solder layers, is set to 5 seconds or longer, and 15 minutes or shorter.

21. An apparatus for manufacturing an electronic device which has a first electronic component and a second electronic component, the first electronic component having a first terminal having formed on the surface thereof a solder layer, and the second electronic component having a second terminal to be bonded to the first terminal of the first electronic component, the apparatus comprising:
a container in which a plurality of stacks, each obtained by stacking the first electronic component and the second electronic component, while placing between the first terminal and the second terminal a resin layer which contains a flux-active compound and a thermosetting resin, are arranged;
a heating unit heating the stacks in the container up to a temperature not lower than the melting point of the solder layers on the first terminals;
a pressurized fluid introducing unit introducing a pressurized fluid into the container; and
a clamping unit clamping the plurality of stacks in the container in the direction of stacking of the stacks, and applying load onto the individual stacks in the direction of stacking of the individual stacks,
the clamping unit being configured:
to have a member having trenches formed thereon; and so that,
when the individual stacks are clamped by the clamping unit, the first electronic components or the second electronic components of the individual stacks are brought into contact with the individual areas of the member partitioned by the trenches; and
the trenches of the member are opposed to gaps formed between the adjacent stacks and formed between the adjacent components brought into contact with the individual areas partitioned by the trenches.

22. The apparatus for manufacturing an electronic device according to Claim 21,
configured so that, when the member having the trenches formed thereon is brought into contact with the stacks,
the end faces of the first electronic components or the second electronic components, brought into contact with the areas partitioned by the trenches, project out from the side faces of the trenches inwards the trenches.
